# EUROPÄISCHE PATENTSCHRIFT

(11) **EP 0 859 960 B1**
(45) Veröffentlichungstag und Bekanntmachung des Hinweises auf die Patenterteilung: **23.04.2003**
(21) Anmeldenummer: 97933619.5
(22) Anmeldetag: 04.07.1997
(51) Int. Cl.: G01P 21/02

(54) **VORRICHTUNG UND VERFAHREN ZUR ÜBERWACHUNG VON SENSOREN IN EINEM FAHRZEUG**
DEVICE AND METHOD TO MONITOR SENSORS IN VEHICLES
DISPOSITIF ET PROCEDE DE SURVEILLANCE DE CAPTEURS DANS UN VEHICULE

(30) Priorität: 07.09.1996 DE 19636443
(43) Veröffentlichungstag der Anmeldung: 26.08.1998
(73) Patentinhaber: ROBERT BOSCH GMBH, 70442 Stuttgart (DE)
(72) Erfinder: MERGENTHALER, Rolf-Hermann, D-71229 Leonberg (DE); URBAN, Werner, D-71655 Vaihingen (DE); VOLKART, Asmus, D-74321 Bietigheim-Bissingen (DE)
(86) Internationale Anmeldenummer: DE9701410
(87) Internationale Veröffentlichungsnummer: WO98010297

(56) Entgegenhaltungen:
- WO-A-86/06172
- WO-A-95/26285
- DE-A- 4 230 295
- US-A- 5 140 524
- "NORMALIZED MEASUREMENT COMPARISON (NMC) MEANS FOR AUTOMOTIVE POWERTRAIN (PT)/-CHASSIS (CH) SYSTEMS' ANGULAR SPEED SENSOR AND/OR PT MECHANICAL SLIP DIAGNOSTICS" RESEARCH DISCLOSURE, Nr. 352, 1.August 1993, EMSWORTH, Seite 504 XP000395236
- ZANTEN VAN A ET AL: "FDR - DIE FAHRDYNAMIK-REGELUNG VON BOSCH" ATZ AUTOMOBILTECHNISCHE ZEITSCHRIFT, Bd. 96, Nr. 11, 1.November 1994, STUTTGART, Seiten 674-678, 683 - 689, XP000478694 in der Anmeldung erwähnt

## Beschreibung

### Stand der Technik

Die Erfindung betrifft eine Vorrichtung und ein Verfahren zur Überwachung von in einem Fahrzeug eingesetzten Sensoren. Insbesondere dient die Vorrichtung bzw. das Verfahren der Überwachung der Sensoren, die in einem System zur Regelung der Fahrdynamik eines Fahrzeuges eingesetzt werden.

Vorrichtungen und Verfahren zur Überwachung von in einem Fahrzeug eingesetzten Sensoren sind aus dem Stand der Technik in vielerlei Modifikationen bekannt.

Aus der DE-OS 35 13 937 ist ein Verfahren zur Überwachung eines Drehzahlgebersignals bekannt, bei dem das Drehzahlgebersignal nicht nur hinsichtlich seines Vorhandenseins überprüft wird, sondern zusätzlich auch im Hinblick auf seine Plausibilität. Die Plausibilitätsüberwachung des als Impulsfolge vorliegenden Drehzahlgebersignals findet dadurch statt, daß ausgehend vom Drehzahlgebersignal ein Zeitwert ermittelt wird, welcher den zeitlichen Abstand der einzelnen Impulse des aktuellen Drehzahlgebersignals beschreibt. Für den aktuellen Zeitwert werden Grenzwerte vorgegeben, die jeweils wenigstens abhängig vom letzten Drehzahlgebersignal sind. Überschreitet der aktuelle Zeitwert diese Grenzwerte nach oben bzw. nach unten, so erkennt die Überwachung, daß das aktuelle Drehzahlgebersignal nicht sinnvoll ist und daß folglich ein Fehler des Drehzahlgebers vorliegt. Befindet sich dagegen der aktuelle Zeitwert innerhalb der vorgegebenen Grenzen, so wird das Drehzahlgebersignal zur Weiterverarbeitung weitergegeben.

Die unter dem Aktenzeichen 195 10 525.7 beim Deutschen Patentamt eingereichte Patentanmeldung beschreibt ein Verfahren und eine Vorrichtung zur Steuerung bzw. Regelung der Bremsanlage eines Fahrzeuges. Bei diesem Verfahren bzw. bei dieser Vorrichtung wird die Bremspedalbetätigung durch wenigstens zwei, vorzugsweise diversitäre Meßeinrichtungen erfaßt. Bei einer bevorzugten Realisierung erfaßt beispielsweise die erste Meßeinrichtung den vom Pedal zurückgelegten Weg, die zweite Meßeinrichtung die vom Fahrer auf das Pedal ausgeübte Betätigungskraft. In einer im Verfahren bzw. in der Vorrichtung enthaltenen Fehlererkennung werden zunächst das den Pedalweg repräsentierende Signal bzw. das die Pedalkraft repräsentierende Signal auf Plausibilität überprüft. Hierzu wird die jeweilige Signalamplitude bzw. der jeweilige Signalgradient mit einer entsprechenden Schwelle verglichen. Ergibt sich bei diesen Plausibilitätsvergleichen, daß beide Sensorsignale plausibel sind, so wird sowohl, ausgehend von dem den Pedalweg repräsentierenden Signal, als auch ausgehend von dem die Pedalkraft repräsentierenden Signal, jeweils eine gewünschte Bremskraft auf den Fahrzeugschwerpunkt berechnet, die den Bremswunsch des Fahrers repräsentiert. Die aus den beiden Bremskräften gebildete Differenz wird mit einer vorgegebenen Schwelle verglichen. Ist die Differenz kleiner als die vorgegebene Schwelle, so kann davon ausgegangen werden, daß die Bremswunschermittlung fehlerfrei funktioniert und daß auch die Sensoren fehlerfrei sind. Ergibt sich dagegen, daß entweder die Sensorsignale nicht plausibel sind oder daß die aus den Bremskräften ermittelte Differenz größer als die vorgegebene Schwelle ist, so wird untersucht, welcher der beiden Sensoren fehlerhaft ist. Diese Untersuchung wird anhand der aus den beiden Sensorsignalen ermittelten Bremskräfte und einer aus dem Signal eines dritten Sensors ermittelten Referenzgröße durchgeführt. Ausgehend von den Abweichungen der jeweiligen Bremskraft von der Referenzgröße, wird ermittelt, welcher der beiden Sensoren fehlerhaft ist.

Systeme zur Regelung der Fahrdynamik eines Fahrzeuges sind beispielsweise aus der in der Automobiltechnischen Zeitschrift (ATZ) 96, 1994, Heft 11, auf den Seiten 674 bis 689 erschienenen Veröffentlichung "FDR - die Fahrdynamikregelung von Bosch" bekannt. Gleichzeitig zeigt diese Veröffentlichung, daß eine Sensorüberwachung dadurch realisiert werden kann, daß in einer Modellrechnung geprüft wird, ob die über die Fahrzeugbewegung determinierten Beziehungen zwischen den Sensorsignalen nicht verletzt werden. Außerdem zeigt diese Veröffentlichung, daß die Modelle auch dazu genutzt werden können, um die innerhalb der Sensorspezifikationen auftretenden Sensoroffsets zu berechnen und zu kompensieren.

Aus der WO 95/26285 ist eine Schaltungsanordnung zum Auswerten der Signale eines Giergeschwindigkeitssensors bekannt, welche sich insbesondere für eine Fahrstabilitätsregelung für Kraftfahrzeuge eignet. Sie weist ein Steuergerät auf, dem die Signale des Giergeschwindigkeitssensors und weiterer Sensoren, die fahrzustandsabhängige Größen erfassen - z.B. Raddrehzahl-, Lenkradwinkel-, Querbeschleunigungs- und Längsbeschleunigungssensor, zugeführt werden. Das Steuergerät berechnet aus einem oder mehreren dieser Sensoren eine Referenzgiergeschwindigkeit und vergleicht sie mit der von einem Giergeschwindigkeitssensor gemessenen Giergeschwindigkeit. Außerdem wird unter Beachtung des Fahrzustands die Plausibilität des Giergeschwindigkeitsensorsignals überprüft. Liegt die Differenz zwischen beiden Giergeschwindigkeiten über einem vorgegebenen Schwellwert, wird die Beachtung des Ergebnisses der Plausibilitätsprüfung des Giergeschwindigkeitssensors als fehlerhaft erkannt.

Die Merkmale der Oberbegriffe der unabhängigen Ansprüche sind der WO 95/26285 entnommen.

Die Aufgabe der vorliegenden Erfindung besteht darin, die Überwachung von in einem Fahrzeug eingesetzten Sensoren bzw. die Korrektur der von in einem Fahrzeug eingesetzten Sensoren erzeugten Signale zu verbessern.

### Vorteile der Erfindung

Der Vorteil der Erfindung gegenüber dem eingangs genannten Stand der Technik ist der, daß bei der erfindungsgemäßen Vorrichtung, bzw. dem erfindungsgemäßen Verfahren zur Überwachung der in einem Fahrzeug eingesetzten Sensoren bzw. zur Korrektur der von ihnen erzeugten Signale, keine weiteren, d.h. redundanten Sensoren erforderlich sind. Um ohne redundante Sensoren auskommen zu können, werden hierzu die von den im Fahrzeug enthaltenen Sensoren erzeugten Signale, die jeweils unterschiedliche physikalische Größen repräsentieren, Mitteln zugeführt, mit denen für wenigstens zwei Sensoren, ausgehend von den von den Sensoren erzeugten Signalen, für die Sensoren gleich definierte Vergleichsgrößen ermittelt werden. In Abhängigkeit von wenigstens den ermittelten Vergleichsgrößen wird in weiteren Mitteln eine Referenzgröße ermittelt. Ausgehend von dieser Referenzgröße wird für wenigstens einen Sensor eine Überwachung durchgeführt. Ferner wird wenigstens in Abhängigkeit der Referenzgröße in einem weiteren Mittel für wenigstens einen Sensor eine Korrektur des von ihm erzeugten Signals durchgeführt.

Der Kern der Erfindung besteht darin, die Referenzgröße mit Hilfe eines Vergleichs der Vergleichsgrößen zu ermitteln. Hierzu wird wenigstens die Vergleichsgröße ermittelt, die den größten Abstand von der zuletzt ermittelten Referenzgröße aufweist. Da aufgrund des größten Abstandes davon ausgegangen werden kann, daß der zugehörige Sensor offensichtlich fehlerhaft ist, bleibt diese Vergleichsgröße bei der Ermittlung der Referenzgröße unberücksichtigt. Dabei wird die Referenzgröße ausgehend von den zwischen den Vergleichsgrößen vorhandenen Abständen und den Vergleichsgrößen selbst, durch Bildung eines gewichteten Mittelwertes ermittelt.

In den Mitteln, mit denen wenigstens für einen Sensor eine Korrektur des von ihm erzeugten Signals durchgeführt wird, wird vorteilhafterweise in Abhängigkeit von dem von dem jeweiligen Sensor erzeugten Signal ein den Offset dieses Bignals repräsentierendes Signal ermittelt. Ausgehend von diesem und dem mit dem Sensor erzeugten Signal wird ein korrigiertes Signal des Sensors ermittelt. Dieses korrigierte Signal wird zur Ermittlung der Vergleichsgröße für den jeweiligen Sensor verwendet.

Ein weiterer Vorteil besteht darin, daß die Mittel zur Überwachung wenigstens des einen Sensors, ferner Mittel enthalten, mit denen für diesen Sensor, wenigstens in Abhängigkeit von der Referenzgröße und vorzugsweise unter Verwendung eines inversen mathematischen Modells, eine für den jeweiligen Sensor geltende Sensorreferenzgröße ermittelt wird. Diese Sensorreferenzgröße geht in die Überwachung des Sensors ein. Außerdem wird sie vorzugsweise den Korrekturmitteln zugeführt und steht somit zur Korrektur des vom Sensor erzeugten Signals zur Verfügung. Somit steht sowohl bei der Überwachung des wenigstens einen Sensors als auch bei der Korrektur des von ihm erzeugten Signals eine sensorspezifische Referenzgröße zur Verfügung.

Ein weiterer Vorteil ergibt sich durch die in den Mitteln zur Überwachung wenigstens für einen Sensor enthaltenen zwei Fehlerauswertemittel. Mit einem ersten Fehlerauswertemittel ist wenigstens in Abhängigkeit des Signals, welches den Offset des von dem zu überwachenden Sensor erzeugten Signals repräsentiert, ein erster Sensorfehler ermittelbar. Mit einem zweiten Fehlerauswertemittel, dem wenigstens das von dem zu überwachenden Sensor erzeugte Signal, die Sensorreferenzgröße sowie zusätzlich wenigstens ein Signal, welches eine zulässige sensorspezifische Abweichung repräsentiert. zugeführt werden, ist ein zweiter Sensorfehler ermittelbar. Folglich können durch die zwei Fehlerauswertemittel unabhängig voneinander zwei verschiedene Sensorfehler detektiert werden.

Die Ermittlung der für die Sensoren gleich definierten Vergleichsgrößen erfolgt vorteilhafterweise unter Verwendung von mathematischen Modellen, die auf ihre Gültigkeit hin überprüfbar sind.

Vorteilhafterweise kann die erfindungsgemäße Vorrichtung bzw. das erfindungsgemäße Verfahren in einem System zur Regelung der Fahrdynamik eines Fahrzeuges eingesetzt werden. In diesem Fall handelt es sich bei der zu überwachenden Sensorik beispielsweise um einen ersten Sensor, der ein die Giergeschwindigkeit des Fahrzeuges repräsentierendes Signal erzeugt, um einen zweiten Sensor, der ein die Querbeschleunigung des Fahrzeugs repräsentierendes Signal erzeugt, um einen dritten Sensor, der ein den Lenkwinkel repräsentierendes Signal erzeugt, sowie um den Rädern des Fahrzeugs zugeordnete vierte Sensoren, die die jeweiligen Raddrehzahlen bzw. Radgeschwindigkeiten repräsentierende Signale erzeugen.

Von besonderem Vorteil ist es, wenn die ermittelten, gleich definierten Vergleichsgrößen eine physikalische Größe repräsentieren, die vorzugsweise einer mit einem der im Fahrzeug enthaltenen Sensoren erfaßten Größe entspricht. In diesem Fall ist für den Sensor, dessen erfaßte physikalische Größe der der gleich definierten Vergleichsgrößen entspricht, nicht unbedingt eine Verarbeitung des von ihm erzeugten Signals in einem mathematischen bzw. inversen mathematischen Modell erforderlich. Wird die erfindungsgemäße Vorrichtung bzw. das erfindungsgemäße Verfahren in einem System zur Regelung der Fahrdynamik eines Fahrzeuges eingesetzt, so ist es von Vorteil, als physikalische Größe für die gleich definierten Vergleichsgrößen insbesondere die Giergeschwindigkeit zu verwenden.

Weiterhin ist es vorteilhaft, wenn die ermittelte Referenzgröße eine physikalische Größe repräsentiert, die vorzugsweise einer mit einem der im Fahrzeug enthaltenen Sensoren erfaßten Größe entspricht. Von besonderem Vorteil ist es, wenn die gleich definierten Vergleichsgrößen und die ermittelte Referenzgröße dieselbe physikalische Größe repräsentieren.

Weitere vorteilhafte Ausgestaltungen der Erfindung können den Unteransprüchen entnommen werden.

### Zeichnung

Die Zeichnung besteht aus den Figuren 1 bis 10. Figur 1 zeigt beispielhaft ein Fahrzeug, welches mit einem System zur Regelung der Fahrdynamik ausgestattet ist. In Figur 2 ist zum einen die in einem System zur Regelung der Fahrdynamik eines Fahrzeuges verwendete Sensorik bzw. Aktuatorik und zum anderen eine Strukturierung des in diesem System verwendeten Steuergerätes dargestellt. Figur 3 zeigt in einem Übersichtsblockschaltbild die erfindungsgemäße Vorrichtung, wie sie für eine beliebige Anzahl von Sensoren bzw. für beliebige Sensoren aufgebaut ist. In den Figuren 4a bzw. 4b ist die erfindungsgemäße Vorrichtung dargestellt, wie sie beispielsweise in einem System zur Regelung der Fahrdynamik eines Fahrzeuges eingesetzt wird. In Figur 5 sind die Mittel zur Überwachung des Drehratensensors dargestellt. Die Figuren 6a bzw. 6b zeigen in Flußdiagrammen einen Teil der in den Überwachungsmitteln für den Drehratensensor ablaufenden Überwachung. In Figur 7 sind die Mittel zur Überwachung des Lenkwinkelsensors dargestellt. Das Flußdiagramm in Figur 8 zeigt einen Teil der in den Mitteln zur Überwachung des Lenkwinkelsensors ablaufenden Überwachung. Figur 9 zeigt die Mittel zur Überwachung des Querbeschleunigungssensors. Einen Teil der in den Überwachungsmitteln für den Querbeschleunigungssensors ablaufenden Überwachung zeigt das Flußdiagramm in Figur 10.

In den Figuren sind identische Komponenten mit derselben Ziffer gekennzeichnet.

### Ausführungsbeispiel

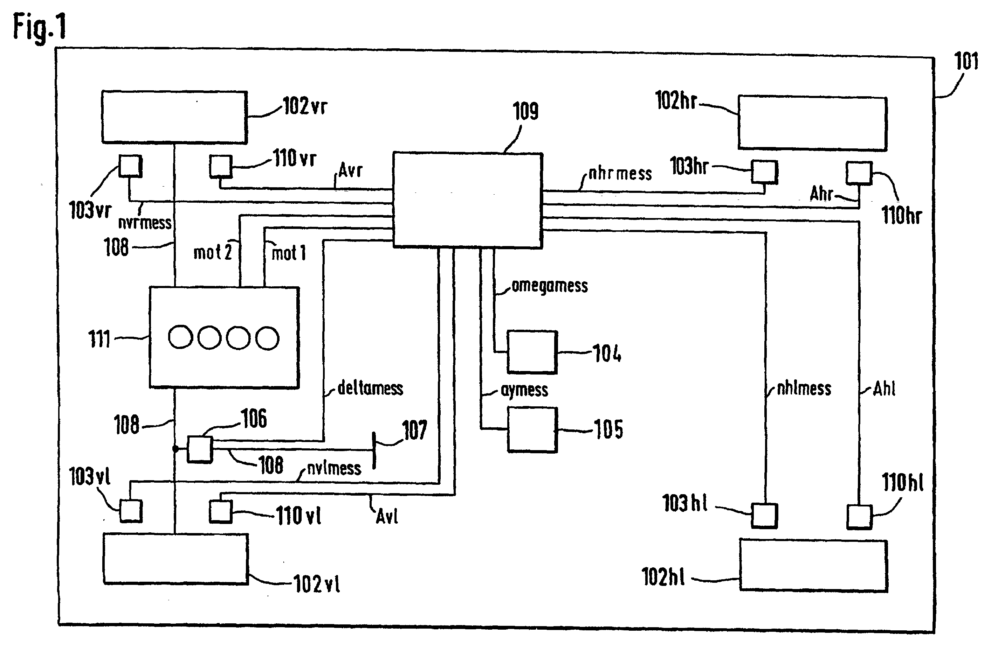

Die Erfindung soll nun anhand der Figuren 1 bis 10 beschrieben werden.

Die spezielle Form des gewählten Ausführungsbeispiels - der Einsatz der erfindungsgemäßen Vorrichtung bzw. des erfindungsgemäßen Verfahrens in einem System zur Regelung der Fahrdynamik eines Fahrzeuges - soll keine Einschränkung der erfindungsgemäßen Idee darstellen.

In Figur 1 ist ein Fahrzeug 101 mit Rädern 102vr, 102vl, 102hr bzw. 102hl dargestellt. Nachfolgend wird für die Räder des Fahrzeuges die vereinfachende Schreibweise 102i eingeführt. Dabei gibt der Index i an, ob sich das Rad an der Hinterachse (h) oder an der Vorderachse (v) befindet. Der Index j zeigt die Zuordnung zur rechten (r) bzw. zur linken (1) Fahrzeugseite an. Diese Kennzeichnung durch die beiden Indizes i bzw. j ist für sämtliche Größen bzw. Komponenten, bei denen sie Verwendung findet, entsprechend.

Jedem Rad 102ij ist ein Raddrehzahlsensor 103ij zugewiesen. Das vom jeweiligen Raddrehzahlsensor 103ij erzeugte Signal nijmess wird dem Steuergerät 109 zugeführt. Neben den Raddrehzahlsensoren 103ij sind im Fahrzeug 101 weitere Sensoren vorhanden. Hierbei handelt es sich um einen Drehraten- bzw. Gierratensensor 104, dessen Signal omegamess ebenfalls dem Steuergerät 109 zugeführt wird. Des weiteren handelt es sich um einen Querbeschleunigungssensor 105. Das von ihm erzeugte Signal aymess wird ebenfalls dem Steuergerät 109 zugeführt. Zusätzlich ist im Fahrzeug ein Lenkwinkelsensor 106 enthalten, mit dem der vom Fahrer über das Lenkrad 107 und das Lenkgestänge 108 an den Vorderrädern eingestellte Lenkwinkel erfaßt wird. Das vom Lenkwinkelsensor 106 erzeugte Signal deltamess wird dem Steuergerät 109 zugeführt. Ferner werden vom Motor 111 aktuelle Motorkenndaten mot2, wie beispielsweise Motordrehzahl und/oder Drosselklappenventilstellung und/oder Zündwinkel dem Steuergerät 109 zugeführt.

Im Steuergerät 109 werden die ihm zugeführten Signale verarbeitet bzw. ausgewertet und entsprechend der Regelung der Fahrdynamik des Fahrzeugs Stellsignale ausgegeben. Es ist denkbar, daß das Steuergerät 109 Stellsignale Aij erzeugt, mit denen den Rädern 102ij zugeordnete Aktuatoren 110ij, welche vorzugsweise Bremsen sind, beeinflußt werden können. Außerdem ist die Ausgabe eines Stellsignals mot1 denkbar, mit dem das vom Motor 111 abgegebene Antriebsmoment beeinflußbar ist.

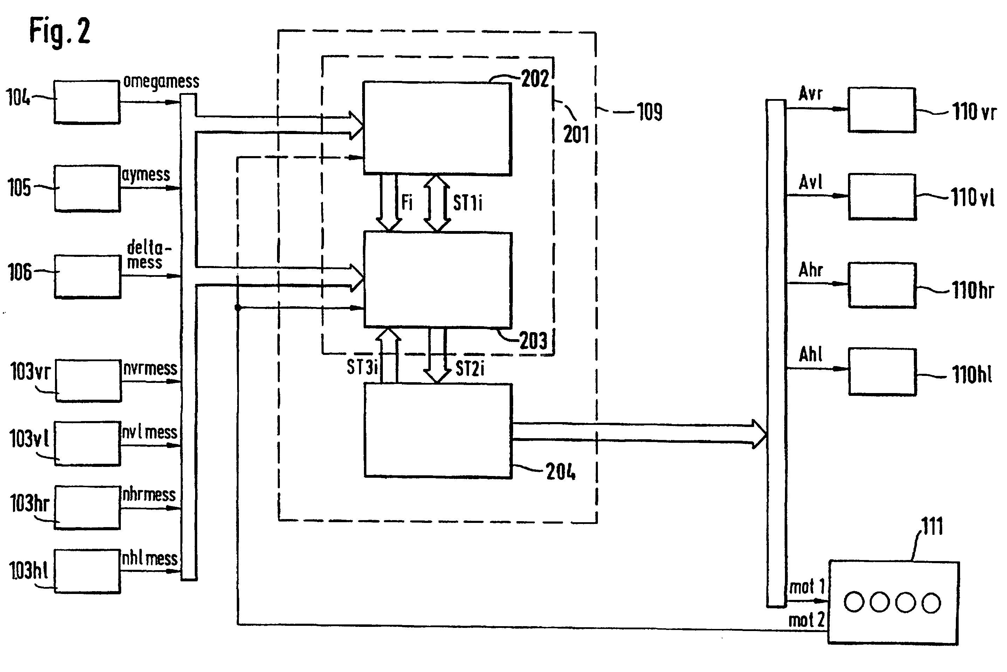

In Figur 2 ist der für die erfindungsgemäße Vorrichtung bzw. für das erfindungsgemäße Verfahren relevante Aufbau des Steuergerätes 109 dargestellt. Im wesentlichen besteht das Steuergerät 109 aus einem Regler 201 und einer Ansteuereinrichtung 204 für die Aktuatoren. Der Regler 201 ist wiederum aus einer Überwachungseinheit 202 und einem Reglerkern 203 aufgebaut. Die von den Sensoren 103ij, 104, 105 bzw. 106 erzeugten Signale werden der Überwachungseinheit 202 zur Überwachung eben dieser Sensoren zugeführt. Zum anderen können diese Signale, je nach Realisierung des Reglerkerns 203, optional auch dem Reglerkern 203 zugeführt werden. Die Motorkenndaten mot2 des Motors 111 werden ebenfalls dem Reglerkern 203 zugeführt. Optional können diese auch der Überwachungseinheit 202 zugeleitet werden. Zwischen der Überwachungseinheit 202 und dem Reglerkern 203 werden Steuersignale ST1i ausgetauscht. Beispielsweise können der Überwachungseinheit 202 vom Reglerkern 203 Signale zugeleitet werden, die zur Überprüfung der durchgeführten Sensorüberwachung erforderlich sind. Gleichzeitig können dem Reglerkern 203 von der Überwachungseinheit 202 beispielsweise Korrekturwerte übermittelt werden, mit denen die jeweiligen Sensorsignale zu korrigieren sind. Mit den Signalen Fi erhält der Reglerkern 203 von der Überwachungseinheit 202 Information darüber, welcher Sensor fehlerhaft ist.

Ausgehend von den dem Reglerkern 203 zugeführten Signalen erzeugt dieser die Ansteuersignale ST2i, die der Ansteuereinrichtung 204 für die Aktuatoren zugeführt wird. Gleichzeitig erhält der Reglerkern 203 von der Ansteuereinrichtung 204 für die Aktuatoren Signale ST3i, die dem Reglerkern 203 beispielsweise den Zustand der Ansteuereinrichtung mitteilen. In Abhängigkeit der erhaltenen Signale ST2i erzeugt die Ansteuereinrichtung 204 für die Aktuatoren die Signale Aij, mit denen die Aktuatoren 110ij beaufschlagt werden. Außerdem erzeugt die Ansteuereinrichtung 204 für die Aktuatoren die Signale mot1, mit denen der Motor 111 bzw. das vom Motor abgegebene Antriebsmoment beeinflußt wird.

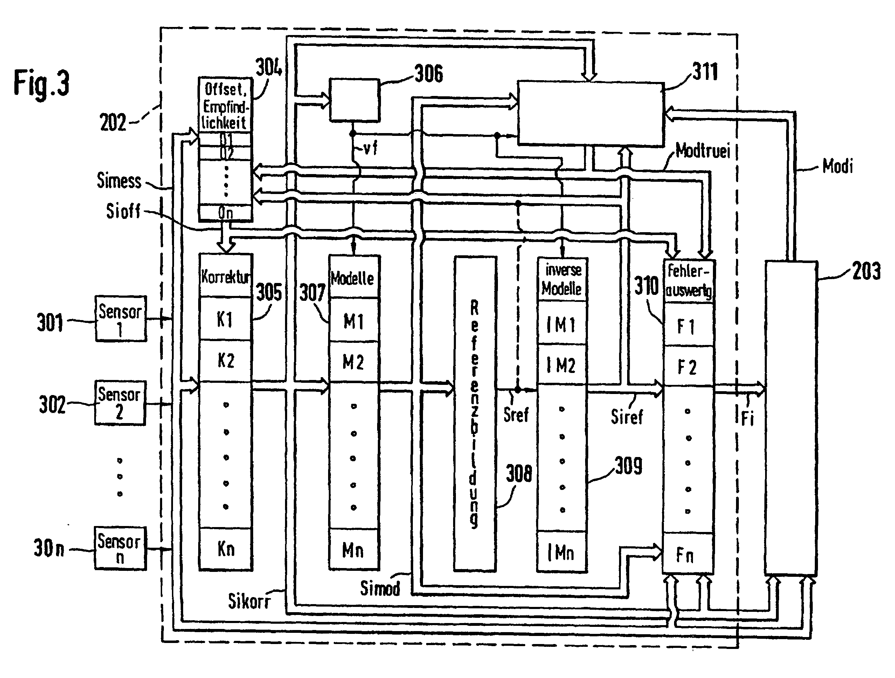

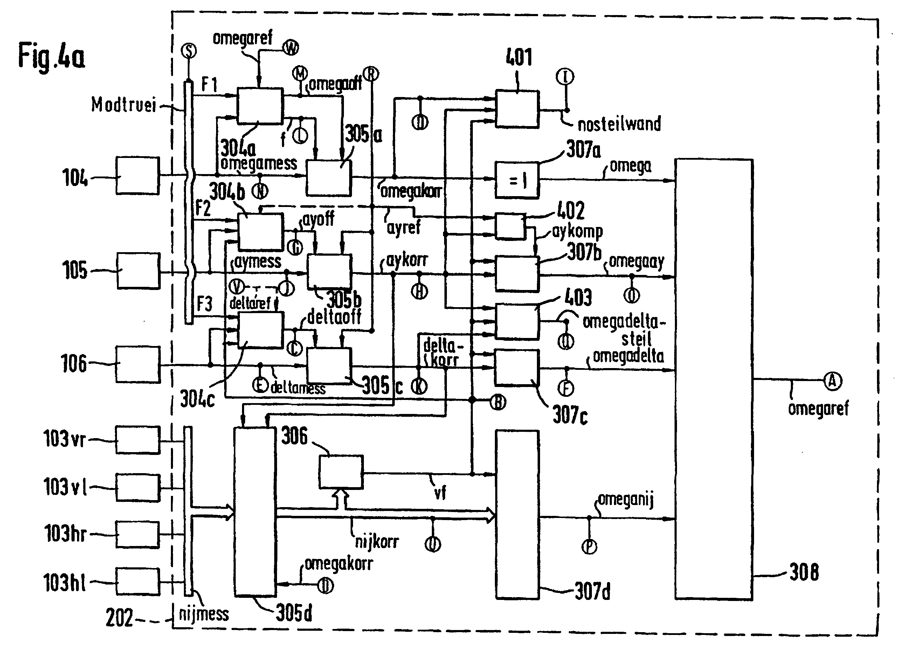

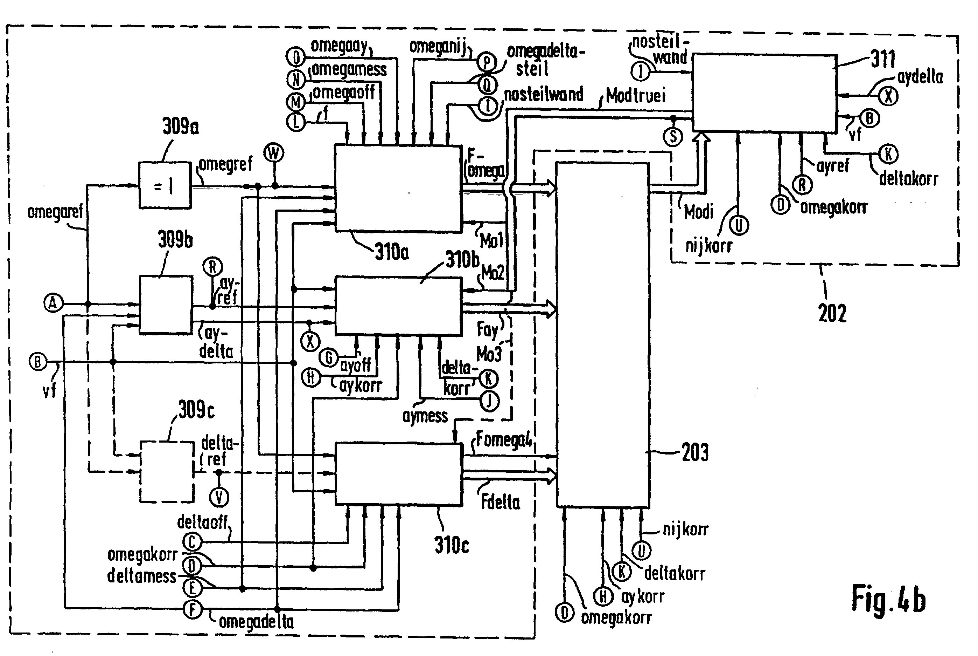

In Figur 3 wird der Aufbau der Überwachungseinheit 202 beschrieben. Hierbei wurde in Figur 3 ein Aufbau der Überwachungseinheit 202 gewählt, der unabhängig von der im Fahrzeug enthaltenen Sensorkonfiguration bzw. unabhängig von dem für das Fahrzeug verwendeten Regelungssystem ist. In diesem allgemeinen Aufbau der Überwachungseinheit 202 findet sich der in den Figuren 4a bzw. 4b dargestellte, für das System zur Regelung der Fahrdynamik des Fahrzeuges dargestellte Aufbau der Überwachungseinheit 202 im wesentlichen wieder. Allerdings können zwischen der allgemeinen Darstellung in Figur 3 und der konkreteren Darstellung in den Figuren 4a bzw. 4b Unterschiede in den den einzelnen Blöcken zugeführten Signalen bestehen. Ferner enthalten die Figuren 4a bzw. 4b zusätzliche Blöcke, die in Figur 3 nicht dargestellt sind.

Für die in Figur 3 dargestellte Überwachungseinheit 202 wird davon ausgegangen, daß die im Fahrzeug enthaltenen n Sensoren 301, 302 bis 30n überwacht werden sollen. Hierbei sei darauf hingewiesen, daß mit der Überwachungseinheit 202 zum einen allgemein alle n im Fahrzeug enthaltenen Sensoren überwacht werden können. Zum anderen ist es aber auch denkbar, mit der Überwachungseinheit 202 nur einen Teil der n Sensoren zu überwachen.

Die mit den n Sensoren 301, 302 bis 30n erzeugten Signale Simess werden den Blöcken 304, 305, 310 bzw. 203 zugeführt. Ausgehend von den erzeugten Sensorsignalen Simess und unter Berücksichtigung von im Block 304 erzeugten Offsetsignalen Sioff, wobei das entsprechende Signal Sioff den Offset des zugehörigen Signals Simess repräsentiert, werden im Block 305 korrigierte Sensorsignale Sikorr erzeugt. Hierzu ist beispielsweise im Block 305 für jeden der n Sensoren ein Korrekturmittel enthalten. Die im Block 305 erzeugten Signale Sikorr werden den Blöcken 306, 307, 310, 311 und auch dem Block 203 zugeführt.

Die angenommene, aus n Sensoren bestehende Sensorkonfiguration soll auch den Rädern zugeordnete Raddrehzahlsensoren enthalten, mit denen Signale erzeugt werden, die die jeweilige Radgeschwindigkeit repräsentieren. Folglich sind in den korrigierten Signalen Sikorr der Sensoren auch korrigierte Radgeschwindigkeitssignale enthalten. Folglich kann im Block 306 in Abhängigkeit der korrigierten Signale Sikorr der Sensoren ein die Fahrzeuggeschwindigkeit repräsentierendes Signal vf erzeugt werden. Dieses Signal wird den Blöcken 307, 309 sowie 311 zugeführt.

Wenigstens in Abhängigkeit der korrigierten Sensorsignale Sikorr und dem die Fahrzeuggeschwindigkeit repräsentierenden Signal vf werden im Block 307 die für die Sensoren gleich definierten Vergleichsgrößen Simod ermittelt. Die Ermittlung dieser Vergleichsgrößen Simod wird im Block 307 vorzugsweise unter Verwendung von mathematischen Modellen realisiert. Dabei ist es durchaus von Vorteil, für jeden der n Sensoren ein unterschiedliches mathematisches Modell zu verwenden. Die für die Sensoren gleich definierten Vergleichsgrößen Simod werden den Blöcken 308, 310 bzw. 311 zugeführt.

Ausgehend von wenigstens den für die Sensoren gleich definierten Vergleichsgrößen Simod wird im Block 308 eine Referenzgröße Sref ermittelt. Die Referenzgröße Sref kann beispielsweise unter Verwendung geeigneter Gewichtungsverfahren aus den Vergleichsgrößen Simod ermittelt werden. Die Referenzgröße Sref wird einem Block 309 zugeführt. Optional kann sie ebenfalls einem Block 304 zugeführt werden.

Im Block 309 werden vorzugsweise unter Verwendung inverser mathematischer Modelle und wenigstens ausgehend von der Referenzgröße Sref und der Fahrzeuggeschwindigkeit vf für die jeweiligen Sensoren geltende Sensorreferenzgrößen Siref ermittelt. Auch für den Block 309 gilt, entsprechend dem Block 307, daß entweder für jeden der n Sensoren ein eigenes inverses mathematisches Modell verwendet wird, oder aber daß unter Umständen für mehrere Sensoren das gleiche inverse mathematische Modell verwendet werden kann. Die Sensorreferenzgrößen Siref werden den Blöcken 304, 310 bzw. 311 zugeführt.

Im Block 310 findet für jeden der n Sensoren eine Fehlerauswertung statt. Hierzu werden im Block 310 für die n Sensoren die jeweiligen Signale Sioff, die den Offset des vom jeweiligen Sensor erzeugten Signals repräsentieren, die jeweiligen Sensorreferenzgrößen Siref, die von den Sensoren jeweils erzeugten Signale Simess, die jeweiligen korrigierten Sensorsignale Sikorr sowie die jeweilige Vergleichsgröße Simod ausgewertet. Außerdem wird die Fehlerauswertung durch die Signale Modtruei beeinflußt, die dem Block 310 beispielsweise mitteilen, ob die im Block 307 verwendeten Modelle gültig sind. Die im Block 310 für die Sensoren stattfindende Fehlerauswertung kann beispielsweise basierend auf einem Vergleich der Sensorreferenzgrößen Siref mit den korrigierten Sensorsignalen Sikorr stattfinden.

Für jeden der n Sensoren wird im Block 310 ein Signal Fi erzeugt, welches dem Block 203 zugeleitet wird. Mit den Signalen Fi wird angezeigt, ob bzw. welcher Sensor fehlerhaft ist.

Ausgehend von den dem Reglerkern 203 zugeführten Signalen Fi, findet im Reglerkern 203 eine entsprechende Verarbeitung der von den Sensoren abstammenden Signale statt. Wird dem Reglerkern 203 durch die Signale Fi angezeigt, daß keiner der Sensoren fehlerhaft ist, so können im Reglerkern 203 sämtliche von den Sensoren abstammende Signale verarbeitet werden. Wird dagegen dem Reglerkern 203 durch die Signale Fi mitgeteilt, daß ein bestimmter Sensor fehlerhaft ist, so kann unter Umständen eine Verzweigung in Fehlerbehandlungsroutinen stattfinden. Beispielsweise kann in einem solchen Fall der Reglerkern 203 dazu übergehen, das vom fehlerhaften Sensor erzeugte Signal bei der Ermittlung der für die Regelung erforderlichen Größen nicht mehr weiter zu berücksichtigen. Ebenso wäre denkbar, daß der Reglerkern 203 in einen für das jeweilige im Fahrzeug implementierte Regelsystem spezifizierten Notlauf übergeht, was unter Umständen so weit gehen kann, daß das Regelsystem abgeschaltet werden kann. Außerdem ist es denkbar, daß das Vorhandensein eines fehlerhaften Sensors dem Fahrer mitgeteilt wird.

Ausgehend vom Block 203 können dem Block 311 Signale Modi zugeführt werden, die bei der Ermittlung, ob die verwendeten mathematischen bzw. inversen mathematischen Modelle gültig sind, berücksichtigt werden können. Beispielsweise können dies Signale sein, die eine Information über die Spannungsversorgung bei einzelnen, im Steuergerät vorhandenen Komponenten enthalten bzw. die eine Information über beispielsweise auftretende Kurz- bzw. Nebenschlüsse enthalten.

Bezüglich der dem Reglerkern 203 zugeführten und von den n Sensoren abstammenden Signalen bestehen mehrere Zuführungs- bzw. Verarbeitungsvarianten. Eine Variante besteht darin, dem Reglerkern 203 die von den Sensoren erzeugten Signale Simess sowie die Offsetsignale Sioff zuzuführen. Somit können im Reglerkern die korrigierten Sensorsignale eigenständig ermittelt werden. Eine andere Variante besteht darin, dem Reglerkern 203 lediglich die korrigierten Sensorsignale Sikorr zuzuführen.

Ausgehend von den dem Block 311 zugeführten Signalen Sikorr, Simod, Siref, Modi, sowie der Fahrzeuggeschwindigkeit vf wird in diesem Block überprüft, ob die im Block 307 verwendeten mathematischen Modelle bzw. ob die im Block 309 verwendeten inversen mathematischen Modelle Gültigkeit haben. Die im Block 311 stattfindende Überprüfung kann beispielsweise auf Plausibilitätsabfragen basieren, die ausgehend von den korrigierten Sensorsignale Sikorr durchgeführt werden. Das Ergebnis dieser Überprüfung wird den Blöcken 304 bzw. 310 zugeführt.

Wie bereits erwähnt, werden im Block 304 die den Offset des jeweiligen Signals repräsentierenden Signale Sioff ermittelt. Hierzu werden dem Block 304 als Eingangsgrößen die von den Sensoren ermittelten Signale Simess, die Sensorreferenzgrößen Siref sowie die Signale Modtruei zugeführt. Die Signale Sioff können beispielsweise durch Filterung der von den Sensoren erzeugten Signale Simess erzeugt werden. Die Signale Sioff werden sowohl dem Block 305 als auch dem Block 310 zugeführt.

Neben der Erzeugung der Signale Sioff, die den jeweiligen Offset der von den Sensoren erzeugten Signale Simess repräsentieren, können im Block 304 auch Signale erzeugt werden, die die Empfindlichkeit der einzelnen Sensoren repräsentieren.

Durch die Darstellung in Figur 3 wird angedeutet, daß in den Blöcken 304, 305, 307, 309 bzw. 310 für jeden der n Sensoren spezifische Mittel vorgesehen sind. Es ist jedoch durchaus denkbar, daß für mehrere Sensoren in diesen Blöcken auch ein Mittel verwendet werden kann.

Ferner zeigt die Darstellung in Figur 3, daß es sich bei dem in der erfindungsgemäßen Vorrichtung ablaufenden erfindungsgemäßen Verfahren, offensichtlich um ein zyklisches Verfahren handelt. Dies zeigt sich beispielsweise daran, daß die Sensorreferenzgrößen Siref in die Ermittlung der Signale Sioff eingehen. Die Signale Sioff gehen wiederum in die Ermittlung der Signale Sikorr ein, von denen ausgehend die Sensorreferenzgrößen Siref ermittelt werden.

Die Blöcke 304 bzw. 305 können von ihren Funktionen her, zusammenfassend als Mittel betrachtet werden, mit denen wenigstens für einen Sensor eine Korrektur des von ihm erzeugten Signals durchgeführt wird. Ebenso können die Mittel 309 bzw. 310 zusammenfassend als Mittel betrachtet werden, mit denen wenigstens für einen Sensor eine Überwachung durchgeführt werden kann.

In den Figuren 4a bzw. 4b ist der Aufbau der Überwachungseinheit 202 dargestellt, wie er beispielsweise in einem Steuergerät für die Regelung der Fahrdynamik eines Fahrzeuges zum Einsatz kommt. Das anhand der Figuren 4a bzw. 4b dargestellte Ausführungsbeispiel soll keine Einschränkung der erfindungsgemäßen Vorrichtung bzw. des erfindungsgemäßen Verfahrens darstellen. Außerdem sei darauf hingewiesen, daß in Figur 3 der prinzipielle Aufbau der Überwachungseinheit 202 dargestellt ist. Insofern können sich durchaus Unterschiede zwischen der Figur 3 und den Figuren 4a bzw. 4b ergeben, was beispielsweise die verwendeten Blöcke bzw. die den Blöcken zugeführten Signale angeht.

Das vom Drehratensensor 104 erzeugte Signal omegamess wird sowohl einem Block 304a bzw. einem Block 305a zugeführt. Im Block 304a wird zum einen das Signal omegaoff ermittelt, welches den Offset des vom Sensor 104 erzeugten Signals omegamess repräsentiert. Zum anderen wird im Block 304a ein Signal f ermittelt, welches die Empfindlichkeit des Drehratensensors 104 repräsentiert. Sowohl das Signal omegaoff als auch das Signal f werden beide einem Block 305a zugeführt.

Neben dem Signal omegamess werden dem Block 304a weitere Signale zugeführt. Zum einen handelt es sich um ein Signal F1, welches in einem Block 311 erzeugt wird und welches wenigstens eine Information darüber enthält, ob die verwendeten mathematischen bzw. inversen mathematischen Modelle Gültigkeit haben. In Abhängigkeit des im Block 304a verwendeten Verfahrens zur Bestimmung der Größe omegaoff kann das Signal F1 weitere, für das jeweilige Verfahren erforderliche Information enthalten. Zum anderen wird dem Block 304a ein in einem Block 309a erzeugtes Signal omegaref zugeführt, welches für den Drehratensensor 104 die Sensorreferenzgröße darstellt.

Wird dem Block 304a über das Signal F1 mitgeteilt, daß die verwendeten mathematischen bzw. inversen mathematischen Modelle Gültigkeit haben, so werden die Größen omegaoff bzw. f aus den Größen omegamess bzw. omegaref ermittelt. Sowohl für die Ermittlung der Empfindlichkeit f des Drehratensensors 104 als auch für die Ermittlung der Größe omegaoff, den Offset des vom Drehratensensor 104 erzeugten Signals omegamess, kann beispielsweise ein Parameterschätzverfahren verwendet werden, bei dem beide Größen ausgehend von den Signalen omegamess bzw. omegaref geschätzt werden. Die Größe f kann beispielsweise alternativ zum Parameterschätzverfahren auch ausgehend von einem Vergleich der Größen omegamess bzw. omegaref durch einen iterativen Prozeß ermittelt werden. Bei dem iterativen Prozeß wird versucht, die Größe omegamess durch Variation der Größe f an die Größe omegaref anzugleichen. Der iterative Prozeß wird beendet, sobald sich die Größe omegamess an die Größe omegaref angeglichen hat. Alternativ zum Parameterschätzverfahren für die Größe omegaoff kann diese beispielsweise durch Filterung unter Verwendung der Größen omegamess und/oder omegaref ermittelt werden.

Wird dem Block 304a durch die Größe F1 mitgeteilt, daß die verwendeten mathematischen bzw. inversen mathematischen Modelle nicht gültig sind, so können beispielsweise die zuletzt für die Größen f bzw. omegaref ermittelten Werte solange beibehalten werden, bis die mathematischen bzw. inversen mathematischen Modelle wieder Gültigkeit haben.

Es ist denkbar, daß im Block 304a für die Ermittlung der Größen f bzw. omegaoff mehrere Verfahren installiert sind.

In Abhängigkeit des jeweiligen Fahrzeugzustandes kann beispielsweise über das Signal F1 das momentan am geeignetsten erscheinende Verfahren aktiviert werden.

Ausgehend von den Größen omegamess, f bzw. omegaoff wird im Block 305a ein korrigiertes Signal omegakorr gebildet. Hierzu kann beispielsweise die Abweichung zwischen den Signalen omegamess bzw. omegaoff ermittelt werden und diese Abweichung mit der Empfindlichkeit f bewertet werden.

Das im Block 305a erzeugte Signal omegakorr wird sowohl einem Block 307a als auch einem Block 401 zugeführt.

Im vorliegenden Ausführungsbeispiel sei angenommen, daß die für die Sensoren gleich definierten Vergleichsgrößen als physikalische Größe eine Giergeschwindigkeit repräsentieren. Aus diesem Grund handelt es sich bei dem im Block 307a implementierten mathematischen Modell um eine Multiplikation mit 1, da die korrigierte Größe omegakorr nicht umgerechnet werden muß. Folglich sind in diesem Fall die Größen omegakorr bzw. omega identisch. Für den Fall jedoch, daß die für die Sensoren gleich definierten Vergleichsgrößen eine andere physikalische Größe repräsentieren sollen, muß im Block 307a ein mathematisches Modell implementiert sein, mit dem es möglich ist, die Größe omegakorr entsprechend in die geforderte physikalische Größe umzurechnen. Das im Block 307a erzeugte Signal omega wird einem Block 308 zugeführt.

Das vom Querbeschleunigungssensor 105, erzeugte Signal aymess wird sowohl einem Block 304b als auch einem Block 305b zugeführt.

Zusätzlich zum Signal aymess werden dem Block 304b ein vom Block 311 erzeugte Signal F2 sowie ein in einem Block 306 erzeugte Signal vf, welches die Fahrzeuggeschwindigkeit repräsentiert, zugeführt. Optional kann dem Block 304b das mit einem Block 309b erzeugte Sensorreferenzsignal ayref zugeführt werden. Entsprechend dem Signal F1 enthält auch das Signal F2 wenigstens eine Information darüber, ob die verwendeten mathematischen bzw. inversen mathematischen Modelle Gültigkeit haben. Sofern für diese Gültigkeit besteht, wird im Block 304b das Signal ayoff ermittelt, welches den Offset des vom Querbeschleunigungssensor 105 erzeugten Signals aymess repräsentiert. Für die Ermittlung des Signals ayoff bieten sich mehrere Verfahren an. Beispielsweise kann das Signal ayoff mittels einer Langzeitfilterung aus dem Signal aymess ermittelt werden, wobei die Filterzeit beispielsweise in Abhängigkeit der Fahrzeuggeschwindigkeit vf gewählt werden kann. Alternativ hierzu kann das Signal ayoff beispielsweise ausgehend von der Abweichung der Größen ayref bzw. aymess ermittelt werden. Für den Fall, daß im Block 304b unterschiedliche Verfahren zur Ermittlung der Größe ayoff implementiert sind, kann ausgehend vom Fahrzustand des Fahrzeuges mit Hilfe des Signals F2 das in der momentanen Situation am besten geeignete Verfahren ausgewählt werden. Das im Block 304b erzeugte Signal ayoff wird dem Block 305b zugeführt.

Wird dem Block 304b durch das Signal F2 mitgeteilt, daß die verwendeten mathematischen bzw. inversen mathematischen Modelle momentan nicht gültig sind, so wird entsprechend der Vorgehensweise des Blockes 304a vorgegangen.

Neben den Größen aymess bzw. ayoff wird dem Block 305b zusätzlich die in einem Block 309b erzeugte Sensorreferenzgröße ayref zugeführt. Im Block 305b wird beispielsweise ausgehend von der Abweichung zwischen den Größen aymess bzw. ayoff durch Filterung die korrigierte Querbeschleunigung aykorr ermittelt. Durch Berücksichtigung der Größe ayref bei der Filterung werden störende Einflüsse auf die Querbeschleunigung, wie sie beispielsweise durch die Wankbewegungen des Fahrzeuges verursacht werden, korrigiert. Das vom Block 305b erzeugte Signal aykorr wird unter anderem den Blöcken 401, 402, 307b bzw. 403 zugeführt.

Zusätzlich zum Signal aykorr wird dem Block 402 als weiteres Eingangssignal die Größe ayref zugeführt. Ausgehend von den Signalen aykorr bzw. ayref wird am Block 402 ein Signal aykomp ermittelt, welches auf der Abweichung zwischen den Signalen ayref bzw. aykorr basiert. Das Signal aykomp kann zur Korrektur nicht abgeglichener Querbeschleunigungsoffsets verwendet werden.

Das vom Block 402 erzeugte Signal aykomp wird dem Block 307b zugeführt. Ferner erhält der Block 307b die im Block 306 erzeugte Fahrzeuggeschwindigkeit vf. Ausgehend von den Signalen aykorr bzw. aykomp und unter Berücksichtigung der Fahrzeuggeschwindigkeit vf wird unter Verwendung eines mathematischen Modells im Block 307b eine Vergleichsgröße omegaay ermittelt. Hierbei ist es durchaus von Vorteil, bei der Ermittlung der Größe omegaay eine Filterung vorzunehmen. Das vom Block 307b erzeugte Signal omegaay wird dem Block 308 zugeführt.

Das vom Lenkwinkelsensor 106 erzeugte Signal deltamess wird sowohl einem Block 304c als auch einem Block 305c zugeführt. Neben dem Signal deltamess erhält der Block 304c ein vom Block 311 erzeugtes Signal F3, sowie die im Block 306 erzeugte Fahrzeuggeschwindigkeit vf und optional eine im Block 309c erzeugte Sensorreferenzgröße deltaref. Ausgehend von diesen Eingangssignalen wird im Block 304c ein Signal deltaoff erzeugt, welches den Offset des vom Lenkwinkelsensor erzeugten Signals deltamess repräsentiert.

Die Größen F1, F2 bzw. F3 sind ein Teil der Signale Modtruei, die im Block 311 erzeugt werden.

Die im Block 304c ablaufende Ermittlung des Signals deltaoff kann entsprechend der im Block 304b ablaufenden Ermittlung des Signals ayoff stattfinden. Das im Block 304c ermittelte Signal deltaoff wird einem Block 305c zugeführt.

Neben den Signalen deltamess bzw. deltaoff wird dem Block 305c zusätzlich das Signal ayref zugeführt. Ausgehend von der Abweichung zwischen den Signalen deltamess bzw. deltaoff und unter Berücksichtigung der Lenkelastizität, die in Abhängigkeit der Größe ayref beschrieben werden kann, wird im Block 305c das korrigierte Signal deltakorr gebildet. Hierbei kann eine Filterung des Signals deltakorr von Vorteil sein.

Das im Block 305c erzeugte Signal deltakorr wird zum einen einem Block 403 und zum anderen einem Block 307c zugeführt. Als weitere Eingangsgröße erhält der Block 307c das im Block 306 erzeugte Signal vf. Ausgehend vom korrigierten Lenkwinkelsignal deltakorr und unter Berücksichtigung der Fahrzeuggeschwindigkeit vf wird im Block 307c unter Verwendung eines mathematischen Modells eine Vergleichsgröße omegadelta ermittelt. Diese wird dem Block 308 zugeführt.

Die von den Raddrehzahlsensoren 103ij erzeugten Signale nijmess, welche die Raddrehzahlen repräsentieren, werden einem Block 305d zugeführt. Ferner erhält der Block 305d als weitere Eingangsgrößen das im Block 305a erzeugte Signal omegakorr, das im Block 305b erzeugte Signal aykorr sowie das im Block 305c erzeugte Signal deltakorr. Ausgehend von den Signalen nijmess werden im Block 305d die korrigierten Radgeschwindigkeiten nijkorr ermittelt. Beispielsweise werden zur Ermittlung der korrigierten Radgeschwindigkeiten nijkorr zunächst die die Raddrehzahlen repräsentierenden Signale nijmess in Radgeschwindigkeiten umgesetzt, die dann gefiltert werden. Anschließend werden ausgehend von diesen gefilterten Größen und unter Berücksichtigung der Größen omegakorr, aykorr sowie deltakorr die korrigierten Radgeschwindigkeiten nijkorr ermittelt. Hierzu kann beispielsweise das in der DE-OS 42 30 295 beschriebene Verfahren zum Einsatz kommen. Die korrigierten Radgeschwindigkeiten nijkorr stellen quasi freirollende, von Reifendurchmessertoleranzen befreite Radgeschwindigkeiten dar.

Die mit Hilfe des Blockes 305d erzeugten korrigierten Radgeschwindigkeiten nijkorr werden sowohl einem Block 306 als auch einem Block 307d zugeführt. Ausgehend von den Signalen nijkorr wird im Block 306 beispielsweise durch Mittelwertbildung das die Fahrzeuggeschwindigkeit repräsentierende Signal vf erzeugt. Das Signal vf wird unter anderem den Blökken 307b, 307c, 307d, 401 sowie 403 zugeführt.

Im Block 307d wird ausgehend von den korrigierten Radgeschwindigkeiten nijkorr und unter Berücksichtigung der Fahrzeuggeschwindigkeit vf mit Hilfe eines mathematischen Modells eine Vergleichsgröße omeganij ermittelt. Diese wird dem Block 308 zugeführt.

Ausgehend von den dem Block 308 zugeführten Vergleichsgrößen omega, omegaay, omegadelta bzw. omeganij wird durch einen Vergleich dieser Vergleichsgrößen eine Referenzgröße omegaref ermittelt. Zur Ermittlung der Referenzgröße omegaref bietet sich beispielsweise an, zunächst diejenige Vergleichsgröße zu ermitteln, die den größten Abstand zu der zuletzt ermittelten Referenzgröße aufweist. Da diese Vergleichsgröße den größten Abstand zu der zuletzt ermittelten Referenzgröße aufweist, kann darauf geschlossen werden, daß unter Umständen der zugehörige Sensor eventuell fehlerhaft ist. Folglich bleibt diese Vergleichsgröße bei der Ermittlung der aktuellen Referenzgröße unberücksichtigt. Die aktuelle Referenzgröße wird durch Bildung eines gewichteten Mittelwertes gebildet. In die Bildung des gewichteten Mittelwertes gehen zum einen die verbleibenden Vergleichsgrößen und zum anderen die zwischen den verbleibenden Vergleichsgrößen vorhandenen Abstände ein. Die Referenzgröße omegaref wird unter anderem den Blöcken 309a, 309b sowie 309c zugeführt.

In einem Block 401 findet ausgehend von den Signalen omegakorr, aykorr sowie vf eine Steilwandkurvenerkennung statt. Hierzu wird beispielsweise die korrigierte Giergeschwindigkeit omegakorr unter Berücksichtigung der Fahrzeuggeschwindigkeit vf in eine Querbeschleunigung umgerechnet. Ausgehend von einem Vergleich zwischen der umgerechneten Querbeschleunigung und der korrigierten Querbeschleunigung aykorr kann festgestellt werden, ob das Fahrzeug eine Steilwandkurve durchfährt. Ist dies der Fall, so wird dem Signal nosteilwand der Wert FALSE zugewiesen. Das Signal nosteilwand wird den Blöcken 310a sowie 311 zugeführt.

In einem Block 403 wird ausgehend von den Größen deltakorr, aykorr sowie vf unter Verwendung eines mathematischen Modells eine Giergeschwindigkeit omegadeltasteil berechnet, bei der die Einflüsse von quergeneigten Fahrbahnen berücksichtigt sind. Diese Größe omegadeltasteil wird einem Block 310a zugeführt. Bezüglich der Giergeschwindigkeit omegadeltasteil sei bemerkt, daß sie zur Überwachung der Sensoren ungeeignet ist, da sie von den Signalen zweier Sensoren (dem Querbeschleunigungssensor 105 sowie dem Lenkwinkelsensor 106) abhängt. Daher wird sie lediglich zur Vermeidung von Fehlabschaltungen der Giergeschwindigkeitsüberwachung bei quergeneigter Fahrbahn verwendet.

Im vorliegenden Ausführungsbeispiel repräsentiert die im Block 308 ermittelte Referenzgröße omegaref eine physikalische Größe, die einer, mit einem der im Fahrzeug enthaltenen Sensoren erfaßten Größe, nämlich der Gierrate entspricht. Aus diesem Grund ist die im Block 309a für den Drehratensensor 104 ermittelte Sensorreferenzgröße identisch mit der Referenzgröße omegaref. D.h., im Block 309a wird als inverses mathematisches Modell zur Ermittlung der Sensorreferenzgröße ausgehend von der Referenzgröße eine Multiplikation mit 1 verwendet. Für den Fall, daß die gleich definierten Vergleichsgrößen nicht der physikalischen Größe Gierrate entsprechen, muß im Block 309a selbstverständlich ein von der Multiplikation mit 1 verschiedenes inverses mathematisches Modell zur Ermittlung der Sensorreferenzgröße für den Drehratensensor 104 verwendet werden. Die im Block 309a ermittelte Sensorreferenzgröße omegaref wird einem Block 310a zugeführt.

Im Block 310a findet die Überwachung des Drehratensensors 104 statt. Zu diesem Zweck werden dem Block 310a neben der Sensorreferenzgröße omegaref weitere Größen zugeführt. Es handelt sich hierbei um die Größe f, welche die Empfindlichkeit des Drehratensensors 104 repräsentiert, um die Größe omegaoff, welche den Offset des vom Drehratensensor erzeugten Signals repräsentiert, um das vom Drehratensensor erzeugte Signal omegamess, um die Vergleichsgröße omegaay, um die Vergleichsgröße omeganij, um das mit dem Lenkwinkelsensor erzeugte Signal deltamess, um die Vergleichsgröße omegadelta, um die Fahrzeuggeschwindigkeit vf, um das Signal omegadeltasteil, um das Signal nosteilwand sowie um ein vom Block 311 erzeugtes Signal Mo1. Ausgehend von diesen Eingangsgrößen erzeugt der Block 310a die Signale Fomega, die eine Information darüber enthalten, ob der Drehratensensor 104 fehlerhaft ist. Diese Signale werden dem Reglerkern 203 zugeführt.

Ausgehend von der Referenzgröße omegaref und unter Berücksichtigung der Fahrzeuggeschwindigkeit vf wird in einem Block 309b mit Hilfe eines inversen mathematischen Modells eine für den Querbeschleunigungssensor 105 geltende Sensorreferenzgröße ayref ermittelt. Diese wird einem Block 310b zugeführt. Entsprechend wird im Block 309b ausgehend von der Vergleichsgröße omegadelta und der Fahrzeuggeschwindigkeit vf unter Verwendung eines inversen mathematischen Modells eine Größe aydelta ermittelt, die ebenfalls dem Block 310b zugeführt wird. Beide Größen, sowohl die Sensorreferenzgröße ayref als auch die Größe aydelta werden bei der im Block 310b stattfindenden Überwachung des Querbeschleunigungssensors 105 verwendet.

Neben den beiden Größen ayref bzw. aydelta werden dem Block 310b zur Überwachung des Querbeschleunigungssensors 105 weitere Größen zugeführt. Hierbei handelt es sich um die Fahrzeuggeschwindigkeit vf, das Signal ayoff, welches den Offset des mit dem Querbeschleunigungssensor 105 erzeugten Signals repräsentiert, um das korrigierte Querbeschleunigungssensorsignal aykorr, um das Signal omegakorr, um das vom Querbeschleunigungssensor 105 erzeugte Signal aymess, um das korrigierte Lenkwinkelsignal deltakorr sowie um ein im Block 311 erzeugtes signal Mo2. Ausgehend von diesen Eingangsgrößen werden im Block 310b Signale Fay erzeugt, welche eine Information darüber enthalten, ob der Querbeschleunigungssensor 105 fehlerhaft ist. Diese Signale Fay werden dem Reglerkern 203 zugeführt.

Ausgehend von der Referenzgröße omegaref und der Fahrzeuggeschwindigkeit vf kann für den Lenkwinkelsensor 106 unter Verwendung eines inversen mathematischen Modells im Block 309c eine Sensorreferenzgröße deltaref ermittelt werden, welche einem Block 310c zugeführt wird. In Figur 4b ist der Block 309c sowie die ihm zugeführten Eingangssignale omegaref bzw. vf sowie das von ihm erzeugte Ausgangssignal deltaref gestrichelt dargestellt, da diese Art der Erzeugung der Sensorreferenzgröße für den Lenkwinkelsensor 106 eine Alternative zu der im Ausführungsbeispiel verwendeten Methode der Ermittlung der Sensorreferenzgröße für den Lenkwinkelsensor 106 darstellt.

Im Block 310c findet die Überwachung des Lenkwinkelsensors 106 statt. Aus diesem Grund werden dem Block 310c das Sensorreferenzsignal omegaref des Drehratensensors 104, das Signal deltaoff, welches den Offset des vom Lenkwinkelsensor 106 erzeugten Signals repräsentiert, das die Fahrzeuggeschwindigkeit repräsentierende Signal vf, die korrigierte Giergeschwindigkeit omegakorr, das vom Lenkwinkelsensor 106 erzeugte Signal deltamess sowie die Vergleichsgröße omegadelta zugeführt. Entsprechend den Blöcken 310a bzw. 310b ist es auch im für den Block 310c denkbar, diesem ein Signal Mo3 zuzuführen, welches eine Information hinsichtlich der Gültigkeit der verwendeten mathematischen bzw. inversen mathematischen Modelle enthält.

Die Signale Mo1, Mo2 bzw. Mo3 sind in den Signalen Modtruei enthalten.

Alternativ zu der im Block 309c stattfindenden Ermittlung der Sensorreferenzgröße deltaref wird im Block 310c ausgehend von der korrigierten Giergeschwindigkeit omegakorr und der Fahrzeuggeschwindigkeit vf unter Verwendung eines inversen mathematischen Modells ein Lenkwinkelreferenzwert ermittelt. Basierend auf diesem Lenkwinkelreferenzwert kann im Block 310c sowohl eine Überwachung des Lenkwinkelsensors 106 als auch eine zusätzliche Überwachung des Drehratensensors 104 durchgeführt werden. Diese zusätzliche Überwachung des Drehratensensors 104 wäre nicht möglich, wenn im Block 310c die Sensorreferenzgröße deltaref anstelle des Lenkwinkelreferenzwertes verwendet werden würde. Die im Block 310c erzeugten Signale Fomega4 sowie Fdelta werden dem Reglerkern 203 zugeleitet.

Ausgehend von den ihm zugeführten Signalen Fomega, Fay, Fomega4 sowie Fdelta, wird im Reglerkern 203 der in ihm ablaufende Regelalgorithmus beeinflußt. Wird dem Reglerkern 203 durch eines dieser Signale mitgeteilt, daß einer der Sensoren 103ij, 104, 105 bzw. 106 fehlerhaft ist, so können beispielsweise im Reglerkern 203 Fehlerbehandlungsroutinen aufgerufen werden.

Durch den Aufruf solcher Fehlerbehandlungsroutinen können beispielsweise die von den fehlerhaften Sensoren erzeugten Signale von der Berechnung der für die Regelung erforderlichen Größen ausgeschlossen und durch Ersatzgrößen, die unter Verwendung der nicht fehlerhaften Sensoren ermittelt werden, ersetzt werden. Alternativ zum Aufruf von Fehlerbehandlungsroutinen ist auch ein sogenannter Reglernotlauf denkbar. Im vorliegenden Ausführungsbeispiel kann bei solch einem Reglernotlauf beispielsweise ein Teil des Systems zur Regelung der Fahrdynamik des Fahrzeuges oder aber auch das komplette System abgeschaltet werden.

Des weiteren werden dem Reglerkern 203 die korrigierten Signale omegakorr, aykorr, deltakorr sowie nijkorr zugeführt. Für den Fall, daß keiner der Sensoren 103ij, 104, 105 bzw. 106 fehlerhaft ist, können im Reglerkern 203 sämtliche korrigierten Signale verarbeitet werden. Alternativ zu den korrigierten Signalen können dem Reglerkern 203, wie bereits im Zusammenhang mit der Figur 3 angedeutet, auch die von den Sensoren erzeugten Signale, sowie die Offsetsignale zugeführt werden, aus denen dann im Reglerkern 203 die korrigierten Signale ermittelt werden können.

Vom Reglerkern 203 werden Signale Modi an den Block 311 übertragen. Diese Signale gehen in die Überprüfung der Gültigkeit der verwendeten mathematischen bzw. inversen mathematischen Modelle ein. Bei den Signalen Modi kann es sich beispielsweise um Signale handeln, die eine Information über den Zustand der Versorgungsspannung bzw. eine Information über evtl. vorliegende Kurz- bzw. Nebenschlüsse beispielsweise der sensorzuleitungen enthält.

Im Block 311 werden in Abhängigkeit der Signale Modi, der korrigierten Signale nijkorr, omegakorr sowie deltakorr, der Sensorreferenzgröße ayref für den Querbeschleunigungssensor 105, der Fahrzeuggeschwindigkeit vf, sowie den Größen aydelta, sowie nosteilwand überprüft, ob die verwendeten mathematischen bzw. inversen mathematischen Modelle Gültigkeit haben. Das Ergebnis dieser Überprüfung wird mittels der Signale Modtruei, die die Signale Mo1, Mo2 und Mo3 sowie F1, F2 bzw. F3 enthalten, ausgegeben.

Zur Überprüfung der verwendeten mathematischen bzw. inversen mathematischen Modelle bieten sich verschiedene Überprüfungsmöglichkeiten an. Ausgehend von den korrigierten Radgeschwindigkeiten nijkorr sind die verwendeten mathematischen bzw. inversen mathematischen Modelle dann gültig, wenn beispielsweise keine der Radgeschwindigkeiten, verglichen mit einem vorgegebenen Schwellwert, innerhalb einer bestimmten Zeit zu schnell abnimmt, oder wenn beispielsweise die Geschwindigkeitsdifferenz zwischen einem Vorderrad und dem seitengleichen Hinterrad kleiner ist als ein vorgegebener Schwellwert.

Ausgehend von dem Signal omegakorr sind die verwendeten mathematischen bzw. inversen mathematischen Modelle beispielsweise dann gültig, wenn sich der Wert des Signals omegakorr innerhalb einer bestimmten Zeitdauer, verglichen mit einem vorgegebenen Schwellwert, nicht stark ändert.

Weitere Modellgültigkeitskriterien lassen sich beispielsweise aus dem korrigierten Signalen ayref bzw. deltakorr ableiten. So ist eine weitere Voraussetzung für die Gültigkeit der verwendeten mathematischen bzw. inversen mathematischen Modelle beispielsweise die, daß der Wert des Signals ayref kleiner als ein Schwellwert ist und/oder der Wert des Signals deltakorr kleiner als ein Schwellwert ist. Ebenso sollte die Fahrzeuggeschwindigkeit vf einen bestimmten Schwellwert überschreiten.

Außerdem sollte, daß die verwendeten mathematischen bzw. inversen mathematischen Modelle gültig sind, beispielsweise die Differenz aus der Sensorreferenzgröße ayref und dem Signal aydelta kleiner als ein vorgegebener Schwellwert sein.

Bei den vorgenannten Überprüfungskriterien handelt es sich um allgemeine, für sämtliche mathematischen bzw. inversen mathematischen Modelle gültige Kriterien. Ergänzend zu diesen allgemeinen Kriterien, kann es durchaus sinnvoll sein, beispielsweise für die Blöcke 304a, 304b bzw. 304c spezielle Kriterien zusätzlich zu verwenden. So kann es beispielsweise für die im Block 304b stattfindende Bestimmung des Signals ayoff wichtig sein, daß das Fahrzeug nicht in einer Steilwandkurve fährt. Aus diesem Grund wird im Block 311 das Signal nosteilwand mitberücksichtigt. Zusätzliche Überwachungskriterien ergeben sich durch die Berücksichtigung der Signale Modi.

Ausgehend von den verschiedenen Möglichkeiten der Modell-überwachung, ist es denkbar, daß in die Signale Mo1, Mo2 sowie Mo3 bzw. F1, F2 sowie F3 unterschiedliche, im Block 311 stattfindende Überprüfungskriterien eingehen.

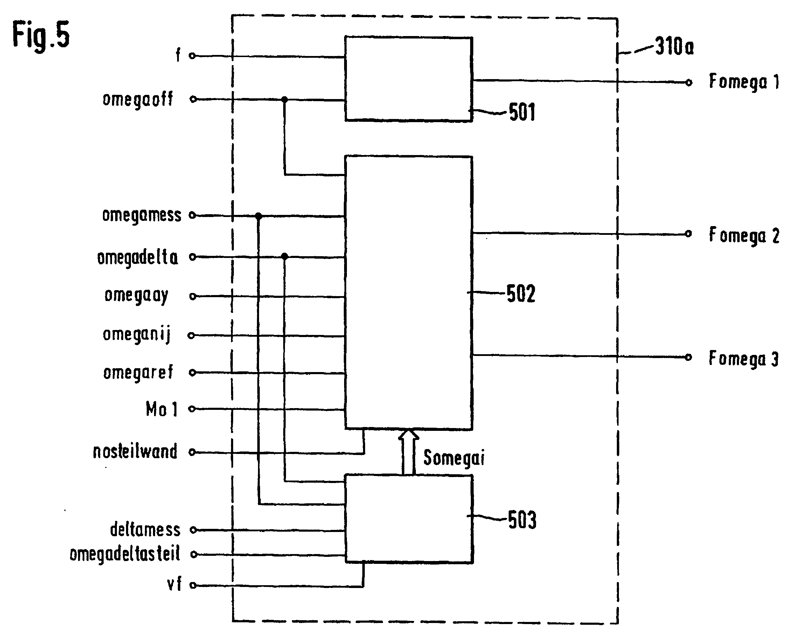

In Figur 5 ist der Aufbau des Blockes 310a, in dem die Überwachung des Drehratensensors 104 stattfindet, dargestellt. Ausgehend von den Signalen f bzw. omegaoff findet in einem ersten Fehlerauswertemittel 501 eine erste Überwachung des Drehratensensors 104 statt, mit der ein erster Fehler des Drehratensensors ermittelbar ist. Hierzu können beispielsweise die Signale f bzw. omegaoff mit Hilfe von Schwellwertvergleichen auf Plausibilität überprüft werden. Die dabei verwendeten Schwellwerte können beispielsweise aus den vom Hersteller des Drehratensensors angegebenen Spezifikationen abgeleitet werden. Das Ergebnis der Plausibilitätsüberprüfungen wird mit Hilfe des Signals Fomega1 ausgegeben. Beispielsweise kann diesem Signal, für den Fall daß der Drehratensensor, ausgehend von den Plausibilitätsüberprüfungen, fehlerhaft sein sollte, der Wert TRUE zugewiesen werden.

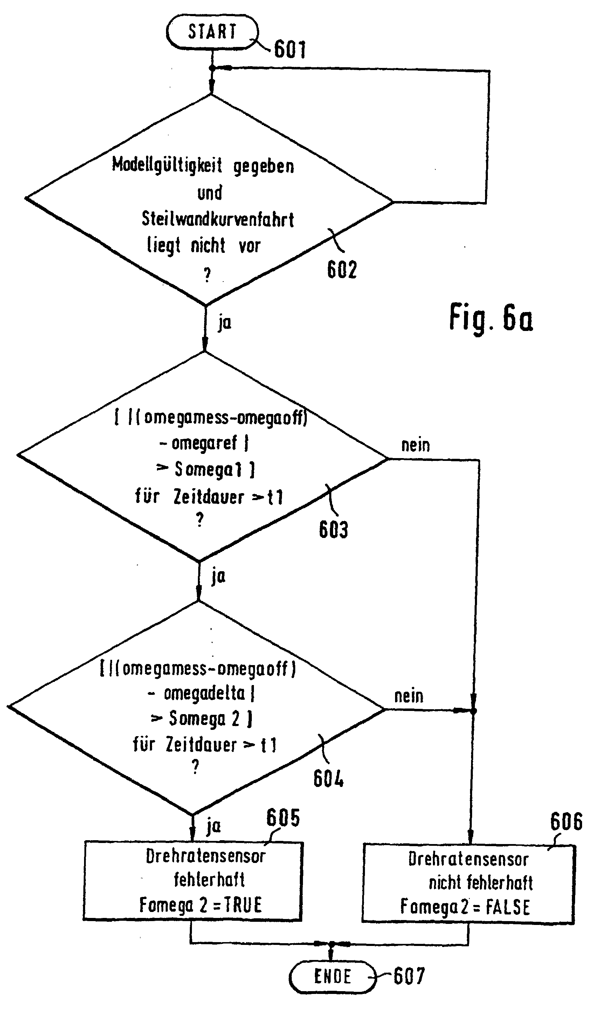

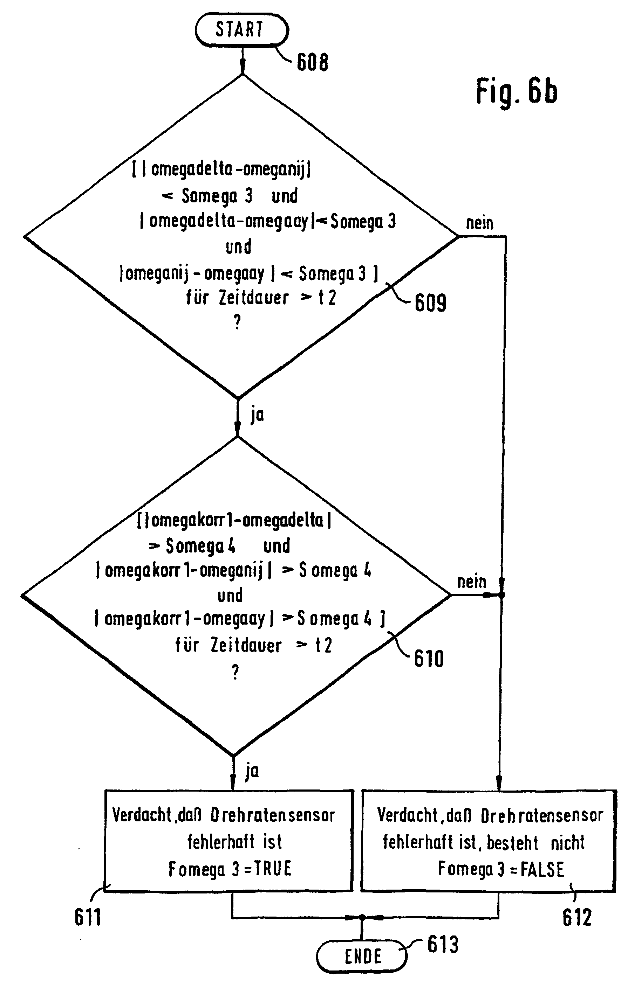

In einem zweiten Fehlerauswertemittel 502 findet eine zweite Überwachung des Drehratensensors 104 statt, mit der ein zweiter Fehler des Drehratensensors ermittelbar ist. Hierzu werden dem Block 502 die Signale omegaoff, omegamess, omegadelta, omegaay, omeganij, omegaref, Mo1, nosteilwand sowie die für die im Block 502 stattfindenden Abfragen benötigten Schwellwerte bzw. zulässigen sensorspezifischen Abweichungen Somegai zugeführt. Ausgehend von den Eingangssignalen finden im Block 502 zwei getrennt ablaufende Überwachungen statt. Die eine findet nur statt, wenn die verwendeten mathematischen bzw. inversen mathematischen Modelle Gültigkeit haben und gleichzeitig keine Steilwandkurvenfahrt vorliegt. Die Modellgültigkeit wird durch das Signal Mol angezeigt, die Steilwandkurvenfahrt durch das Signal nosteilwand. Mit dieser Überwachung kann festgestellt werden, ob der Drehratensensor 104 fehlerhaft ist oder nicht. Das Ergebnis dieser Überwachung wird mit Hilfe des Signals Fomega2 ausgegeben. Mit einer zweiten Überwachung, die unabhängig von der Gültigkeit der verwendeten mathematischen bzw. inversen mathematischen Modelle ausgeführt wird, kann der Verdacht festgestellt werden, ob der Drehratensensor 104 fehlerhaft ist oder nicht. Das Ergebnis dieser Überwachung wird mit Hilfe des Signals Fomega3 ausgegeben. Die beiden im Block 502 stattfindenden Überwachungen werden in den Figuren 6a bzw. 6b näher beschrieben.

In einem Block 503 werden die für die im Block 502 stattfindenden Überwachungen benötigten Schwellwerte bzw. zulässigen sensorspezifischen Abweichungen Somegai beispielsweise ausgehend von den Signalen omegamess, omegadelta, deltamess, omegadeltasteil sowie vf ermittelt. Durch Verwendung der Größen omegadelta bzw. omegadeltasteil wird eine eventuell vorhandene Fahrbahnseitenneigung mitberücksichtigt. Ausgehend von den Größen omegamess, deltamess bzw. vf können beispielsweise Phasenverschiebungen zwischen der Giergeschwindigkeit und dem Lenkwinkel bei schnellen Lenkwinkeländerungen mitberücksichtigt werden.

In Figur 6a ist anhand eines Flußdiagrammes die erste Überwachung der im zweiten Fehlerauswertemittel 502 stattfindenden Überwachungen dargestellt. Diese erste Überwachung beginnt im Schritt 601. Im anschließenden Schritt 602 wird abgefragt, ob die Gültigkeit der verwendeten mathematischen bzw. inversen mathematischen Modelle gegeben ist und gleichzeitig keine Steilwandkurvenfahrt vorliegt. Hierzu wird zum einen der Wert des Signals Mo1 und zum anderen der Wert des Signals nosteilwand überprüft. Ist die Modellgültigkeit nicht gegeben oder liegt eine Steilwandkurvenfahrt vor, so wird der Schritt 602 erneut ausgeführt.

Wird dagegen im Schritt 602 festgestellt, daß gleichzeitig die Modellgültigkeit gegeben ist und keine Steilwandkurvenfahrt vorliegt, so wird als nächstes der Schritt 603 ausgeführt. Im Schritt 603 wird überprüft, ob die Zeitdauer, während der der Betrag der aus (omegamess - omegaoff) und omegaref gebildeten Differenz größer als eine erste Schwelle Somega1 ist, größer als ein vorgegebener Schwellwert t1 ist. Ist die ermittelte Zeitdauer kleiner als der Schwellwert t1, so wird als nächstes der Schritt 606 ausgeführt. Ist dagegen die Zeitdauer größer als der Schwellwert t1, so wird als nächstes der Schritt 604 ausgeführt.

Im Schritt 604 wird überprüft, ob die Zeitdauer, während der der Betrag der aus (omegamess - omegaoff) und omegadelta gebildeten Differenz größer als eine zweite Schwelle Somega2 ist, größer als ein vorgegebener Schwellwert t1 ist. Ist die ermittelte Zeitdauer kleiner als der Schwellwert t1, so wird als nächstes der Schritt 606 ausgeführt. Ist dagegen die Zeitdauer größer als der Schwellwert t1, so wird als nächstes der Schritt 605 ausgeführt.

Im Schritt 605 wird dem Signal Fomega2 der Wert TRUE zugewiesen, da aufgrund der im Schritt 603 bzw. der im Schritt 604 stattfindenden Abfragen feststeht, daß der Drehratensensor 104 fehlerhaft ist. Der Drehratensensor 104 ist deshalb fehlerhaft, weil zum einen im Schritt 603 festgestellt wurde, daß der Betrag der Abweichung, die aus dem vom Drehratensensor erzeugten und offsetkorrigierten Signal, und der Sensorreferenzgröße gebildet wird, während einer Zeitdauer, die größer als ein Schwellwert t1 ist, größer als ein Schwellwert Somega1 ist. Zum anderen wurde im Schritt 604 festgestellt, daß der Betrag der Abweichung, die aus dem vom Drehratensensor erzeugten und offsetkorrigierten Signal, und der Vergleichsgröße omegadelta gebildet wird, während einer Zeitdauer, die größer als ein Schwellwert t1 ist, größer als ein Schwellwert Somega2 ist.

Im Schritt 606 wird dem Signal Fomega2 der Wert FALSE zugewiesen, da aufgrund der in den Schritten 603 bzw. 604 stattfindenden Abfragen feststeht, daß der Drehratensensor nicht fehlerhaft ist.

Anschließend an den Schritt 605 bzw. anschließend an den Schritt 606 wird der Schritt 607 ausgeführt, mit dem die erste Überwachung beendet wird.

Anhand des Flußdiagrammes wird deutlich, daß die Sensorüberwachung nur dann ausgeführt wird, wenn die verwendeten mathematischen bzw. inversen mathematischen Modelle gültig sind.

In Figur 6b ist mit Hilfe eines Flußdiagrammes die im zweiten Auswertemittel 502 stattfindende zweite Überwachung des Drehratensensors 104 dargestellt. Diese zweite Überwachung findet unabhängig von der Gültigkeit der verwendeten mathematischen bzw. inversen mathematischen Modelle statt. Alternativ kann bei dieser zweiten Überwachung, entsprechend der ersten Überwachung, das Vorliegen einer Steilwandkurvenfahrt berücksichtigt werden. Die zweite Überwachung beginnt mit einem Schritt 608. Anschließend an diesen Schritt wird der Schritt 609 ausgeführt.

Im Schritt 609 wird überprüft, ob die Zeitdauer, in der gleichzeitig sowohl der Betrag der Differenz aus omegadelta und omeganij kleiner als Somega3 ist, als auch der Betrag der Differenz aus omegadelta und omegaay kleiner als Somega3 ist, als auch der Betrag der Differenz aus omeganij und omegaay kleiner als Somega3 ist, größer als ein vorgegebener Schwellwert t2 ist. Mit anderen Worten: im Schritt 609 wird überprüft, ob die drei Vergleichsgrößen über eine gewisse Zeit in einem engen Giergeschwindigkeitsband liegen. Wird im Schritt 609 ermittelt, daß die Zeitdauer kleiner als der Schwellwert t2 ist, so wird als nächstes der Schritt 612 ausgeführt.

Wird dagegen im Schritt 609 ermittelt, daß die Zeitdauer größer als der Schwellwert t2 ist, so wird als nächstes der Schritt 610 ausgeführt. Im Schritt 610 wird überprüft, ob die Zeitdauer, in der gleichzeitig sowohl der Betrag der Differenz aus omegakorr1 und omegadelta größer als Somega4 ist, als auch der Betrag der Differenz aus omegakorr1 und omeganij größer als Somega4 ist, als auch der Betrag der Differenz aus omegakorr1 und omegaay größer als Somega4 ist, größer als ein vorgegebener Schwellwert t2 ist. Die Größe omegakorr 1 wird aus dem vom Drehratensensor 104 erzeugten Signal omegamess und dem Signal omegaoff gebildet. Mit anderen Worten: im Schritt 610 wird überprüft, ob der offsetkorrigierte Wert omegakorrl für eine gewisse Zeitdauer einen Mindestabstand zu den drei Vergleichsgrößen aufweist. Ist die im Schritt 610 ermittelte Zeitdauer kleiner als der Schwellwert t2, so wird als nächstes der Schritt 612 ausgeführt. Ist dagegen die Zeitdauer größer als der Schwellwert t2, so wird als nächstes der Schritt 611 ausgeführt.

Im Schritt 611 wird dem Signal Fomega3 der Wert TRUE zugewiesen, da der Verdacht besteht, daß der Drehratensensor fehlerhaft ist. Der Verdacht besteht deshalb, weil zum einen im Schritt 609 ermittelt wurde, daß die drei Vergleichsgrößen über eine gewisse Zeit in einem engen Giergeschwindigkeitsband liegen, und zum anderen im Schritt 610 ermittelt wurde, daß die offsetkorrigierte Größe omegakorrl für eine gewisse Zeit einen Mindestabstand zu den drei Vergleichsgrößen aufweist. Im Schritt 612 wird dem Signal Fomega3 der Wert FALSE zugewiesen, da der Verdacht, daß der Drehratensensor fehlerhaft ist, nicht besteht. Sowohl anschließend an den Schritt 611 als auch anschließend an den Schritt 612 wird der Schritt 613 ausgeführt, mit dem die zweite Überwachung beendet wird.

Die Schwellwerte Somega1, Somega2, Somega3 bzw. Somega4 sind in Figur 5 zu den Signalen Somegai zusammengefaßt.

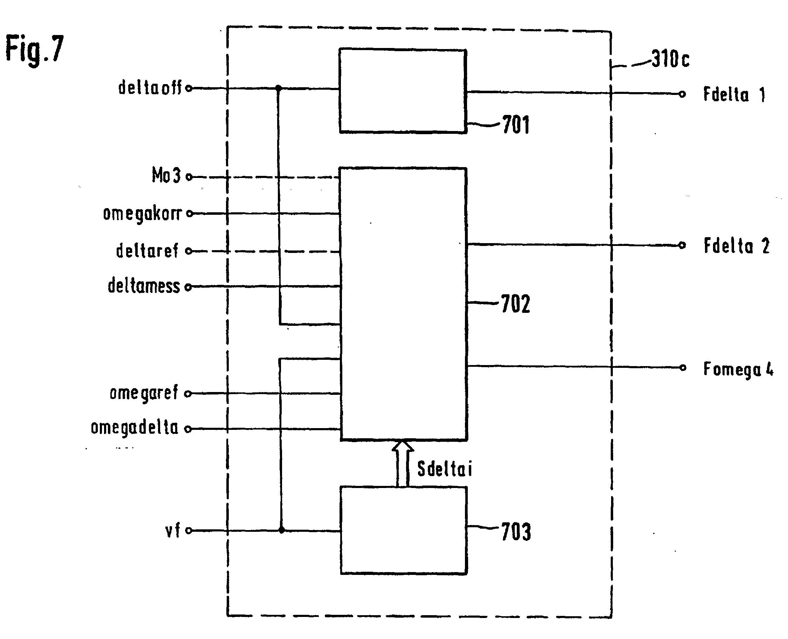

In Figur 7 ist der Aufbau des Blockes 310c dargestellt. Mit einem ersten Fehlerauswertemittel 701 wird ausgehend von dem Signal deltaoff, welches den Offset des vom Lenkwinkelsensor erzeugten Signals präsentiert, ein erster Sensorfehler ermittelt. Hierzu wird das Signal deltaoff beispielsweise anhand von Schwellwertabfragen auf Plausibilität überprüft. Die Schwellwerte können beispielsweise aus den Sensorspezifikationen abgeleitet werden. Das Ergebnis dieser Abfrage wird mit dem Signal Fdeltal ausgegeben.

Mit einem zweiten Fehlerauswertemittel 702 ist ausgehend von den Eingangsgrößen omegakorr, deltamess, deltaoff, vf, omegaref, omegadelta, Sdeltai sowie alternativ den Signalen deltaref bzw. Mo3 ein zweiter Sensorfehler des Lenkwinkelsensors ermittelbar. Des weiteren ist mit dem zweiten Fehlerauswertemittel 702 auch ein Fehler des Drehratensensors ermittelbar. Alternativ kann für die im Block 702 stattfindende Fehlerauswertung entweder die Sensorreferenzgröße deltaref oder eine aus der korrigierten Gierwinkelgeschwindigkeit omegakorr mittels eines mathematischen Modells hergeleitete Größe deltaomega verwendet werden. Das Ergebnis der Fehlerauswertung für den Lenkwinkelsensor wird mit Hilfe des Signals Fdelta2 ausgegeben. Das Ergebnis der Fehlerauswertung für den Drehratensensor wird mit Hilfe des Signals Fomega4 ausgegeben.

In einem Block 703 werden ausgehend von der Fahrzeuggeschwindigkeit vf Schwellwerte Sdeltai berechnet, welche als zulässige, sensorspezifische Abweichungen bei den im zweiten Fehlerauswertemittel 702 stattfindenden Abfragen eingesetzt werden.

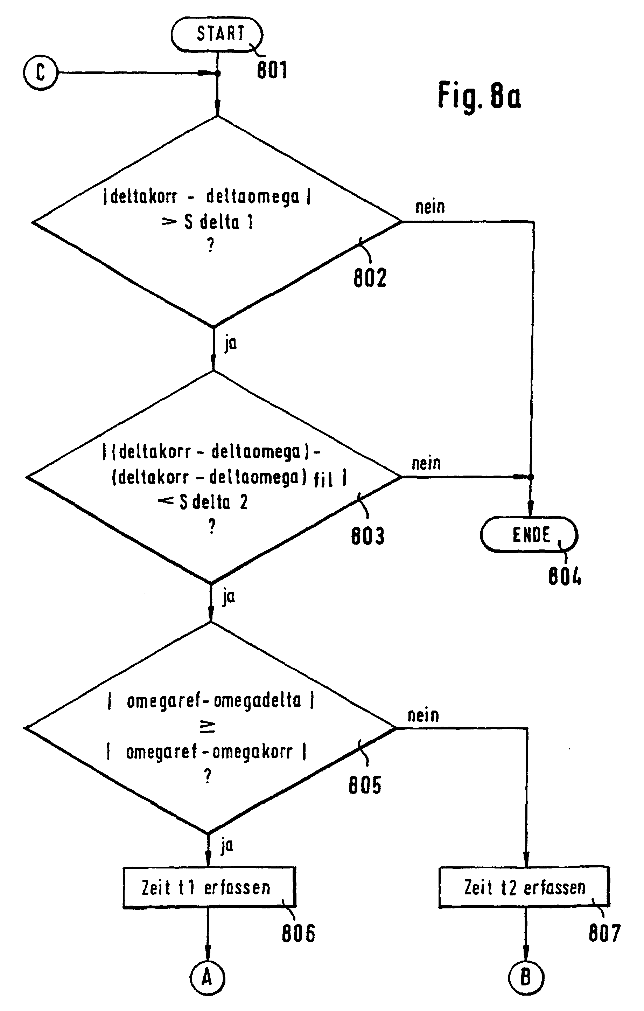

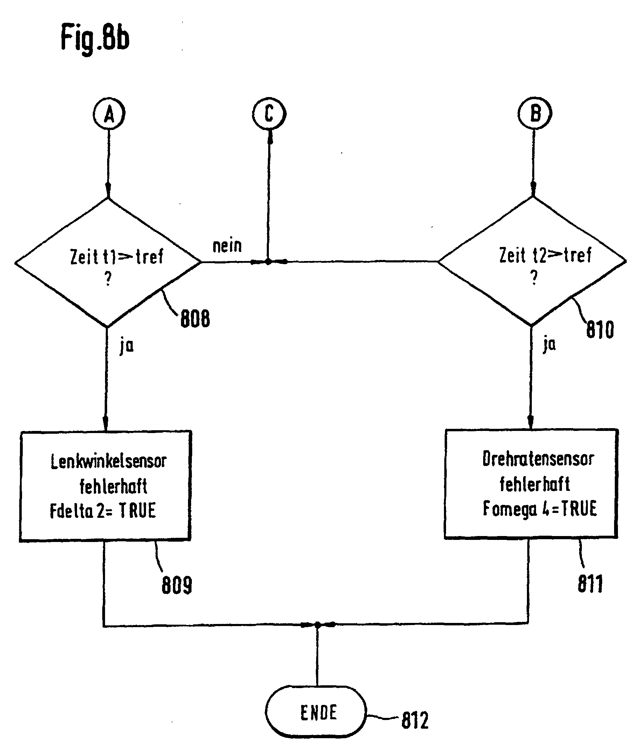

In Figur 8 ist anhand eines Flußdiagrammes die im zweiten Fehlerauswertemittel 702 stattfindende Überwachung des Lenkwinkelsensors dargestellt. Ausgehend von dieser Überwachung kann auch bezüglich des Drehratensensors ein Fehler erkannt werden. Die Überwachung beginnt mit dem Schritt 801, an den sich der Schritt 802 anschließt.

Im Schritt 802 wird überprüft, ob der Betrag der Differenz aus den Größen deltakorr und deltaomega größer als ein Schwellwert Sdelta1 ist. Die Größe deltakorr stellt das vom Lenkwinkelsensor erzeugte und offsetkorrigierte Signal dar. Es geht aus den Signalen deltamess bzw. deltaoff hervor. Die Größe deltaomega stellt einen Referenzwert für das vom Lenkwinkelsensor erzeugte Signal dar, wobei diese Größe ausgehend von der korrigierten Giergeschwindigkeit omegakorr mit Hilfe eines mathematischen Modells gebildet wird. Alternativ zu der Größe deltaomega kann auch die Sensorreferenzgröße deltaref des Lenkwinkelsensors verwendet werden. Wird im Schritt 802 festgestellt, daß der Betrag kleiner als die Schwelle Sdelta 1 ist, was bedeutet, daß das vom Lenkwinkelsensor 106 erzeugte Signal plausibel ist, so wird als nächstes der Schritt 804 ausgeführt.

Wird dagegen im Schritt 802 festgestellt, daß der Betrag größer ist als die Schwelle Sdelta1, was bedeutet, daß das vom Lenkwinkelsensor 106 erzeugte Signal nicht plausibel ist, so wird als nächstes der Schritt 803 ausgeführt.

Im Schritt 803 wird der Fahrzustand des Fahrzeuges auf Stabilität überprüft. Hierzu wird im Schritt 803 überprüft, ob der Betrag der Differenz aus der ungefilterten Abweichung (deltakorr - deltaomega) und der gefilterten Abweichung (deltakorr - deltaomega)_{fil} kleiner ist, als eine Schwelle Sdelta2. Wird im Schritt 803 festgestellt, daß der Betrag größer ist als die Schwelle Sdelta2, d.h. ist der Fahrzustand des Fahrzeuges nicht stabil, so wird als nächstes der Schritt 804 ausgeführt, mit dem die im zweiten Fehlerauswertemittel 702 stattfindende Überwachung beendet wird.

Wird im Schritt 803 dagegen festgestellt, daß der Betrag kleiner als die Schwelle Sdelta2 ist, so wird als nächstes der Schritt 805 ausgeführt.

Im Schritt 805 wird ermittelt, ob der Betrag der Differenz aus omegaref und omegadelta größer gleich dem Betrag der Differenz aus omegaref und omegakorr ist.

Ist der Betrag der Differenz aus omegaref und omegadelta größer gleich dem Betrag der Differenz aus omegaref und omegakorr, was gleichbedeutend damit ist, daß für den Lenkwinkelsensor eine größere Abweichung als für den Drehratensensor vorliegt, so wird als nächstes der Schritt 806 ausgeführt. Im Schritt 806 wird die Zeit t1 erfaßt, während der dieser Zustand vorliegt. Die Zeiterfassung kann beispielsweise dadurch erfolgen, daß bei jedem Aufruf des Schrittes 806 die Zeit um einen inkrementalen Zeitschritt erhöht wird. Im Anschluß an den Schritt 806 wird der Schritt 808 ausgeführt, in welchem die Zeit t1 mit einem Schwellwert tref verglichen wird.

Wird im Schritt 808 festgestellt, daß die Zeit t1 größer als der Schwellwert tref ist, was ein Zeichen dafür ist, daß der Lenkwinkelsensor fehlerhaft ist, so wird als nächstes der Schritt 809 ausgeführt, in welchem dem Signal Fdelta2 der Wert TRUE zugewiesen wird. Anschließend an den Schritt 809 wird der Schritt 812 ausgeführt, mit welchem die Überwachung beendet wird.

Wird im Schritt 808 dagegen festgestellt, daß die Zeit t1 kleiner als der Schwellwert tref ist, so wird erneut der Schritt 802 ausgeführt.

Wird im Schritt 805 festgestellt, daß der Betrag der Differenz aus omegaref und omegadelta kleiner ist als der Betrag der Differenz aus omegaref und omegakorr, so wird als nächstes der Schritt 807 ausgeführt, in welchem die Zeit t2 erfaßt wird, während der dieser Zustand vorliegt. Die Erfassung der Zeit t2 erfolgt entsprechend der Erfassung der Zeit t1 im Schritt 806. Anschließend an den Schritt 807 wird der Schritt 810 ausgeführt, in welchem die Zeit t2 mit dem Schwellwert tref verglichen wird. Wird im Schritt 810 festgestellt, daß die Zeit t2 größer als der Schwellwert tref ist, was ein Zeichen dafür ist, daß der Drehratensensor fehlerhaft ist, so wird als nächstes der Schritt 811 ausgeführt, in welchem dem Signal Fomega4 der Wert TRUE zugewiesen wird. Anschließend an den Schritt 811 wird der Schritt 812 ausgeführt.

Wird dagegen im Schritt 810 festgestellt, daß die Zeit t2 kleiner als der Schwellwert tref ist, so wird erneut der Schritt 802 ausgeführt.

Alternativ kann unter Verwendung des Signals Mo3 zwischen den Schritten 801 und 802 eine Abfrage stattfinden, ob die verwendeten mathematischen bzw. inversen mathematischen Modelle Gültigkeit haben.

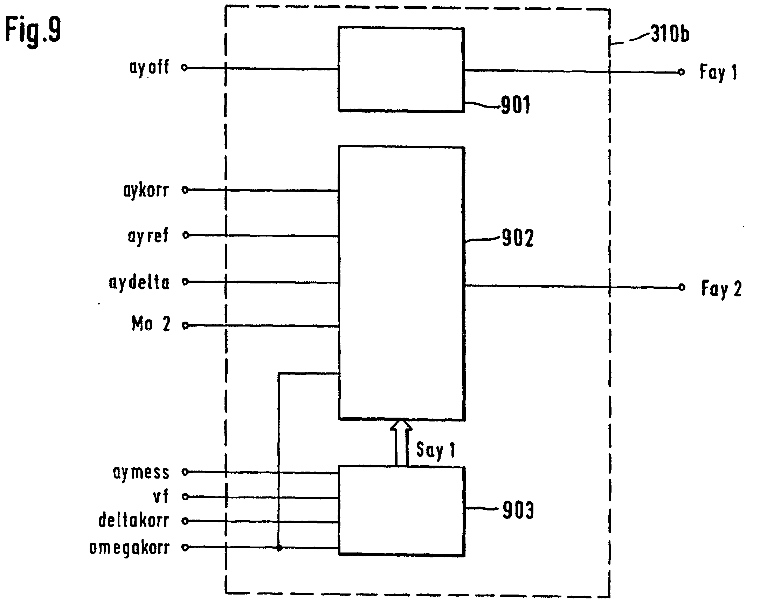

In Figur 9 ist der Aufbau des Blockes 310b dargestellt.

In einem ersten Fehlerauswertemittel 901 ist in Abhängigkeit des Signals ayoff, welches den Offset des vom Querbeschleunigungssensor 105 erzeugten Signals repräsentiert, ein erster Sensorfehler ermittelbar. Die Ermittlung des ersten Sensorfehlers kann entsprechend der für den Block 701 beschriebenen Fehlerermittlung ablaufen. Das Ergebnis der im Block 901 stattfindenden Ermittlung des ersten Sensorfehlers wird mit Hilfe des Signals Fay1 ausgegeben.

In einem zweiten Fehlerauswertemittel 902 wird ausgehend von den Eingangsgrößen aykorr, ayref, aydelta, Mo2, omegakorr sowie der Größe Say1 mittels Plausibilitätsabfragen ein zweiter Sensorfehler ermittelt. Das Ergebnis dieser Ermittlung wird mit Hilfe des Signals Fay2 ausgegeben.

Ausgehend von den Eingangsgrößen aymess, vf, deltakorr sowie omegakorr wird in einem Block 903 die für die Plausibilitätsabfragen im Schritt 902 benötigte Schwelle Say1, welche eine zulässige, sensorspezifische Abweichung darstellt, ermittelt.

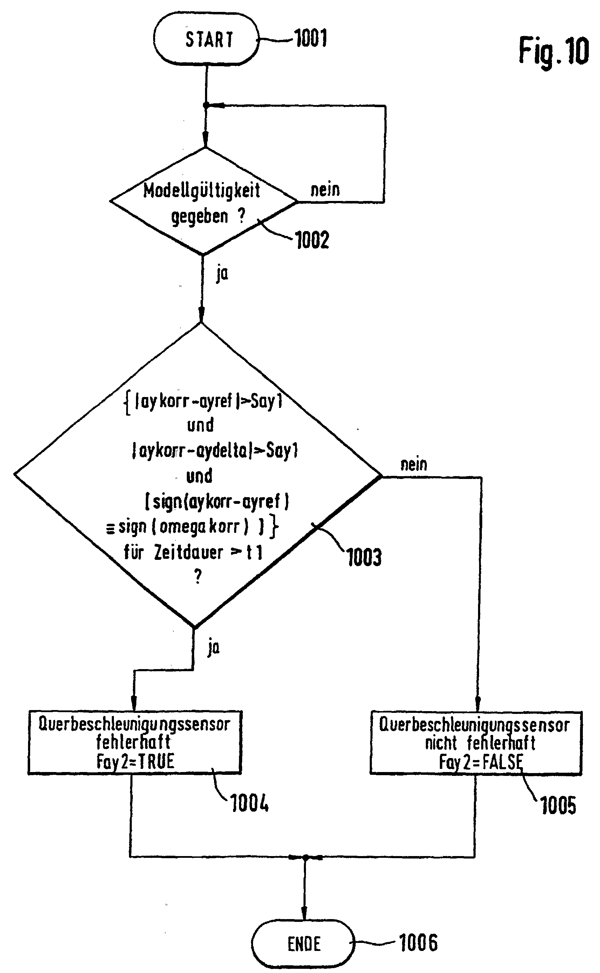

In Figur 10 ist mit Hilfe des Flußdiagrammes die im zweiten Fehlerauswertemittel 902 stattfindende Überwachung des Querbeschleunigungssensors 105 dargestellt.

Die Überwachung des Querbeschleunigungssensors 105 beginnt mit dem Schritt 1001. Anschließend an diesen Schritt wird der Schritt 1002 ausgeführt, in welchem abgefragt wird, ob die Gültigkeit der verwendeten mathematischen bzw. inversen mathematischen Modelle gegeben ist. Ist die Modellgültigkeit nicht gegeben, so wird erneut der Schritt 1002 ausgeführt.

Wird dagegen im Schritt 1002 festgestellt, daß die Modellgültigkeit gegeben ist, so wird als nächstes der Schritt 1003 ausgeführt. Im Schritt 1003 wird überprüft, ob die Zeitdauer, in der gleichzeitig sowohl der Betrag der Differenz aus aykorr und ayref größer als Say1 ist, als auch der Betrag der Differenz aus aykorr und aydelta größer als Say1 ist, als auch die Differenz (aykorr - ayref) und die Größe omegakorr gleiches Vorzeichen haben, größer als ein vorgegebener Schwellwert t1 ist. Die dritte Bedingung dient der Erkennung von geneigten Fahrbahnen.

Wird bei der Abfrage im Schritt 1003 festgestellt, daß die Zeitdauer größer als der Schwellwert t1 ist, was ein Zeichen dafür ist, daß der Querbeschleunigungssensor fehlerhaft ist, wo wird als nächstes der Schritt 1004 ausgeführt, in welchem dem Signal Fay2 der Wert TRUE zugewiesen wird. Wird dagegen im Schritt 1003 festgestellt, daß die Zeitdauer kleiner als der Schwellwert t1 ist, was ein Zeichen dafür ist, daß der Querbeschleunigungssensor nicht fehlerhaft ist, so wird als nächstes der Schritt 1005 ausgeführt, in welchem dem Signal Fay2 der Wert FALSE zugewiesen wird. Sowohl im Anschluß an den Schritt 1004 als auch im Anschluß an den Schritt 1005 wird der Schritt 1006 ausgeführt, mit welchem die Überwachung des Querbeschleunigungssensors 105 beendet wird.

## Patentansprüche

1. Vorrichtung zur Überwachung von Sensoren (301, 302,...,30n) in einem Fahrzeug und/oder zur Korrektur von deren Signalen, wobei die Sensoren (301, 302,...,30n) Signale erzeugen, welche jeweils unterschiedliche physikalische Größen repräsentieren,
welche Mittel (307) enthält, mit denen für wenigstens zwei Sensoren, ausgehend von wenigstens den von ihnen erzeugten Signalen, für die Sensoren (301, 302,...,30n) gleich definierte Vergleichsgrößen ermittelt werden,
welche Mittel (308) enthält, mit denen, in Abhängigkeit von wenigstens den ermittelten Vergleichsgrößen, eine Referenzgröße (Sref) ermittelt wird,
welche Mittel (310) enthält, mit denen wenigstens für einen Sensor (301, 302,...,30n) eine Überwachung, wenigstens ausgehend von der Referenzgröße (Sref), durchgeführt wird und/oder
welche Mittel (305) enthält, mit denen wenigstens für einen Sensor (301, 302,...,30n) eine Korrektur des von ihm erzeugten Signals, wenigstens in Abhängigkeit von der Referenzgröße (Sref), durchgeführt wird,
**dadurch gekennzeichnet,**
**daß** die Mittel (308) zur Ermittlung der Referenzgröße (Sref) so ausgebildet sind, daß durch einen Vergleich der Vergleichsgrößen (Simod) die Referenzgröße (Sref) ermittelt wird, wobei hierzu wenigstens
die Vergleichsgröße (Simod) ermittelt wird, die den größten Abstand zu der zuletzt ermittelten Referenzgröße (Sref) aufweist, und
die zwischen den Vergleichsgrößen (Simod) vorhandenen Abstände ermittelt werden, wobei diese Vergleichsgröße hierbei unberücksichtigt bleibt, und
ausgehend von den Vergleichsgrößen (Simod) und den ermittelten Abständen, durch Bildung eines gewichteten Mittelwertes, die Referenzgröße (Sref) gebildet wird, wobei diese Vergleichsgröße hierbei unberücksichtigt bleibt.

2. Vorrichtung nach Anspruch 1, **dadurch gekennzeichnet,**
**daß** in den Mitteln (305), mit denen wenigstens für einen Sensor (301, 302,..., 30n) eine Korrektur des von ihm erzeugten Signals durchgeführt wird, zusätzlich das von ihm erzeugte Signal berücksichtigt wird, wobei vorzugsweise
in Abhängigkeit von wenigstens dem von dem jeweiligen Sensor (301, 302,..., 30n) erzeugten Signal, ein den Offset dieses Signals repräsentierendes Signal (Sioff) ermittelt wird, und insbesondere
ausgehend von wenigstens dem, den Offset des jeweiligen Signals repräsentierenden Signal (Sioff) und dem mit dem Sensor erzeugten Signal, ein korrigiertes Signal (Sikorr) des Sensors ermittelt wird, und dieses korrigierte Signal (Sikorr) zur Ermittlung der Vergleichsgröße (Sref) verwendet wird.

3. Vorrichtung nach Anspruch 1, **dadurch gekennzeichnet,**
**daß** die Mittel zur Überwachung wenigstens des einen Sensors (301, 302,..., 30n) ferner Mittel (309) enthalten, mit denen für diesen Sensor (301, 302,..., 30n), wenigstens in Abhängigkeit von der Referenzgröße (Sref), und vorzugsweise unter Verwendung eines inversen mathematischen Modells, eine für den jeweiligen Sensor (301, 302,..., 30n) geltende Sensorreferenzgröße (Siref) ermittelt wird, und diese vorzugsweise den Korrekturmitteln zugeführt wird.

4. Vorrichtung nach Anspruch 2 und 3, **dadurch gekennzeichnet, daß** die Mittel zur Überwachung wenigstens des einen Sensors (301, 302,..., 30n), ferner wenigstens enthalten:
erste Fehlerauswertemittel (305), mit denen für diesen Sensor (301, 302,..., 30n), wenigstens in Abhängigkeit des Signals, welches den Offset (Sioff) des von ihm erzeugten Signals repräsentiert, ein erster Sensorfehler (Sikorr) ermittelbar ist, und/oder
zweite Fehlerauswertemittel (310), mit denen für diesen Sensor (301, 302,..., 30n), wenigstens in Abhängigkeit des von ihm erzeugten Signals, der Sensorreferenzgröße (Sref) und wenigstens einem Signal, welches eine zulässige, sensorspezifische Abweichung repräsentiert, ein zweiter Sensorfehler (Fi) ermittelbar ist.

5. Vorrichtung nach Anspruch 1, **dadurch gekennzeichnet,**
**daß** die für die Sensoren (301, 302,..., 30n) gleich definierten Vergleichsgrößen (Simod) unter Verwendung von mathematischen Modellen ermittelt werden,
wobei vorzugsweise die mathematischen Modelle mittels Prüfmittel (203) auf ihre Gültigkeit hin überprüfbar sind.

6. Vorrichtung nach Anspruch 1, **dadurch gekennzeichnet,**
**daß** ein erster Sensor (104) vorhanden ist, der ein die Giergeschwindigkeit des Fahrzeugs repräsentierendes Signal (omegamess) erzeugt,
**daß** ein zweiter Sensor (105) vorhanden ist, der ein die Querbeschleunigung des Fahrzeugs repräsentierendes Signal (aymess) erzeugt,
**daß** ein dritter Sensor (106) vorhanden ist, der ein den Lenkwinkel repräsentierendes Signal (deltamess) erzeugt, und
**daß** den Rädern des Fahrzeugs vierte Sensoren (103vr, 103vl, 103hr, 103hl) zugeordnet sind, die die jeweiligen Radgeschwindigkeiten repräsentierende Signale (nvrmess, nvlmess, nhrmess, nhlmess) erzeugen.

7. Vorrichtung nach Anspruch 1, **dadurch gekennzeichnet,**
**daß** die ermittelten, gleich definierten Vergleichsgrößen (Simod) eine physikalische Größe repräsentieren, die vorzugsweise einer, mit einem der im Fahrzeug enthaltenen Sensoren (301, 302,..., 30n) erfaßten Größe, insbesondere einer Giergeschwindigkeit (omegamess), entspricht, und/oder
**daß** die ermittelte Referenzgröße (Sref), eine physikalische Größe repräsentiert, die vorzugsweise einer, mit einem der im Fahrzeug enthaltenen Sensoren (301, 302,..., 30n) erfaßten Größe, insbesondere einer Giergeschwindigkeit (omegamess), entspricht.

8. Verfahren zur Überwachung von Sensoren (301, 302,..., 30n) in einem Fahrzeug und/oder zur Korrektur von deren Signalen, wobei die Sensoren Signale erzeugen, welche jeweils unterschiedliche physikalische Größen repräsentieren,
bei dem für wenigstens zwei Sensoren (301, 302,..., 30n), ausgehend von wenigstens den von ihnen erzeugten Signalen, für die Sensoren gleich definierte Vergleichsgrößen ermittelt werden,
bei dem, ausgehend von den für die Sensoren (301, 302,..., 30n) ermittelten Vergleichsgrößen, eine Referenzgröße (Sref) ermittelt wird,
bei dem für wenigstens einen Sensor (301, 302,...,30n), ausgehend von der Referenzgröße (Sref), eine Überwachung des Sensorsignals durchgeführt wird und/oder
bei dem für wenigstens einen Sensor (301, 302,...,30n) eine Korrektur des von ihm erzeugten Signals, wenigstens in Abhängigkeit von der Referenzgröße (Sref), durchgeführt wird,
**dadurch gekennzeichnet, dass**,
die Ermittlung der Referenzgröße (Sref) so erfolgt, dass durch einen Vergleich der Vergleichsgrößen (Simod) die Referenzgröße (Sref) ermittelt wird,
wobei hierzu vorzugsweise wenigstens die Vergleichsgröße(Simod) ermittelt wird, die den größten Abstand zu der zuletzt ermittelten Referenzgröße (Sref) aufweist, und
die zwischen den Vergleichsgrößen (Simod) vorhandenen Abstände ermittelt werden, wobei diese Vergleichsgröße hierbei unberücksichtigt bleibt, und
ausgehend von den Vergleichsgrößen (Simod) und den ermittelten Abständen, durch Bildung eines gewichteten Mittelwertes, die Referenzgröße (Sref) gebildet wird, wobei diese Vergleichsgröße hierbei unberücksichtigt bleibt.

## Claims

1. Apparatus for monitoring sensors (301, 302, ..., 30n) in a vehicle and/or for correction of their signals, with the sensors (301, 302, ..., 30n) producing signals which each represent different physical variables,
which contains means (307) by means of which comparison variables, which are defined identically for the sensors (301, 302, ..., 30n), are determined for at least two sensors, based on at least the signals produced by them,
which contains means (308) by means of which a reference variable (Sref) is determined as a function of at least the determined comparison variables,
which contains means (310) by means of which monitoring, at least on the basis of the reference variable (Sref), is carried out at least for one sensor (301, 302, ..., 30n), and/or
which contains means (305) by means of which a correction of the signal which is produced by the sensor (301, 302, ..., 30n) is carried out, at least as a function of the reference variable (Sref), at least for one sensor (301, 302, ..., 30n),
**characterized**
**in that** the means (308) for determining the reference variable (Sref) are designed such that the reference variable (Sref) is determined by means of a comparison of the comparison variables (Simod), in which case, for this purpose, at least the comparison variable (Simod) is determined which is at the greatest distance from the most recently determined reference variable (Sref), and
the distances between the comparison variables (Simod) are determined, with this comparison variable in this case being ignored, and
the reference variable (Sref) is formed by forming a weighted mean value on the basis of the comparison variables (Simod) and the determined distances, with this comparison variable in this case being ignored.

2. Apparatus according to Claim 1, **characterized**
**in that**, in the means (305) by means of which a correction of the signal which is produced by the sensor (301, 302, ..., 30n) is carried out at least for one sensor (301, 302, ..., 30n), the signal which is produced by it is additionally taken into account, preferably
with a signal (Sioff) which represents the offset of this signal being determined as a function of at least the signal which is produced by the respective sensor (301, 302, ..., 30n), and, in particular,
a corrected signal (Sikorr) for the sensor being determined on the basis of at least the signal (Sioff) which represents the offset of the respective signal and the signal produced by that sensor, and this corrected signal (Sikorr) being used for determining the comparison variable (Sref).

3. Apparatus according to Claim 1, **characterized**
**in that** the means for monitoring at least the one sensor (301, 302, ..., 30n) furthermore contains means (309) by means of which a sensor reference variable (Siref) which is applicable to the respective sensor (301, 302, ..., 30n) is determined for this sensor (301, 302, ..., 30n) at least as a function of the reference variable (Siref) and preferably using an inverse mathematical model, and this sensor reference variable (Siref) is preferably supplied to the correction means.

4. Apparatus according to Claims 2 and 3,
**characterized in that** the means for monitoring at least the one sensor (301, 302, ..., 30n) furthermore contain at least:
first fault evaluation means (305) by means of which a first sensor fault (Sikorr) can be determined for this sensor (301, 302, ..., 30n) at least as a function of the signal which represents the offset (Sioff) of the signal which is produced by it, and/or
second fault evaluation means (310), by means of which a second sensor fault (Fi) can be determined for this sensor (301, 302, ..., 30n) at least as a function of the signal which is produced by it, as a function of the sensor reference variable (Sref) and of at least one signal which represents a reliable, sensor-specific error.

5. Apparatus according to Claim 1, **characterized**
**in that** the comparison variables (Simod) which are defined to be the same for the sensors (301, 302, ..., 30n) are determined using mathematical models,
in which case the mathematical models can preferably be checked by means of test means (203) for their validity.

6. Apparatus according to Claim 1, **characterized**
**in that** a first sensor (104) is provided, which produces a signal (omegamess) which represents the yaw rate of the vehicle,
**in that** a second sensor (105) is provided, which produces a signal (aymess) which represents the transverse acceleration of the vehicle,
**in that** a third sensor (106) is provided, which produces a signal (deltamess) which represents the steering angle, and
**in that** fourth sensors (103vr, 103vl, 103hr, 103hl) are associated with the wheels of the vehicle and produce signals (nvrmess, nvlmess, nhrmess, nhlmess) which represent the respective wheel speeds.

7. Apparatus according to Claim 1, **characterized**
**in that** the determined comparison variables (Simod), which are defined to be the same, represent a physical variable which preferably corresponds to a variable which is detected by one of the sensors (301, 302, ..., 30n) which are contained in the vehicle, in particular corresponding to a yaw rate (omegamess), and/or
**in that** the determined reference variable (Sref) represents a physical variable, which preferably corresponds to a variable which is detected by one of the sensors (301, 302, ..., 30n) which are contained in the vehicle, in particular a yaw rate (omegamess).

8. Method for monitoring sensors (301, 302, ..., 30n) in a vehicle and/or for correction of their signals, with the sensors producing signals which each represent different physical variables,
in which comparison variables which are defined to be the same for the sensors are determined for at least two sensors (301, 302, ..., 30n) on the basis of at least the signals which are produced by them,
in which a reference variable (Sref) is determined on the basis of the comparison variables which are determined for the sensors (301, 302, ..., 30n),
in which monitoring of the sensor signal is carried out for at least one sensor (301, 302, ..., 30n) on the basis of the reference variable (Sref), and/or
in which a correction of the signal which is produced by the sensor (301, 302, ..., 30n) is carried out, at least as a function of the reference variable (Sref), for at least one sensor (301, 302, ..., 30n),
**characterized in that**
the reference variable (Sref) is determined such that the reference variable (Sref) is determined by means of a comparison of the comparison variables (Simod),
with preferably at least the comparison variable (Simod) being determined for this purpose which is at the greatest distance from the most recently determined reference variable (Sref), and
the distances which are present between the comparison variables (Simod) being determined, with this comparison variable in this case being ignored, and the reference variable (Sref) being formed by forming a weighted mean value on the basis of the comparison variables (Simod) and the determined distances, with this comparison variable being ignored in this case.

## Revendications

1. Dispositif pour surveiller des capteurs (301, 302, ..., 30n) dans un véhicule et/ou pour corriger leurs signaux, les capteurs (301, 302, ..., 30n) générant des signaux représentant différentes grandeurs physiques, avec
des moyens (307) à l'aide desquels, pour au moins deux capteurs, partant au moins des signaux qu'ils ont générés, pour les capteurs (301, 302, ..., 30n), on a déterminé des grandeurs de comparaison définies de la même manière,
des moyens (308) à l'aide desquels, en fonction au moins des grandeurs de comparaison obtenues on détermine une grandeur de référence (Sref),
des moyens (310) à l'aide desquels pour un capteur (301, 302, ..., 30n) on effectue une surveillance au moins à partir de la grandeur de référence (Sref) et/ou
des moyens (305) à l'aide desquels pour au moins un capteur (301, 302, ..., 30n) on effectue une correction du signal qu'il génère, au moins en fonction de la grandeur de référence (Sref),
**caractérisé en ce que**
les moyens (308) pour déterminer la grandeur de référence (Sref) sont réalisés de façon que par une comparaison des grandeurs de comparaison (Simod) on détermine la grandeur de référence (Sref) et pour cela au moins
on détermine la grandeur de comparaison (Simod) qui présente la plus grande distance par rapport à la grandeur de référence (Sref) déterminée en dernier lieu, et
on détermine les intervalles existants entre les grandeurs de comparaison (Simod) et ces grandeurs de comparaison restent non prises en compte, et
partant des grandeurs de comparaison (Simod) et des distances déterminées, en formant une valeur moyenne pondérée on forme la grandeur de référence (Sref), cette grandeur de comparaison n'étant pas prise en compte ici.

2. Dispositif selon la revendication 1,
**caractérisé en ce que**
dans les moyens (305) à l'aide desquels au moins pour un capteur (301, 302, ..., 30n) on effectue une correction du signal fourni, on tient en outre compte du signal qu'il a généré, et de préférence
en fonction au moins du signal généré par le capteur respectif (301, 302, ..., 30n), on détermine un signal (Sioff) représentant le décalage de ce signal, et notamment
partant au moins du signal (Sioff) représentant le décalage du signal respectif et du signal généré par le capteur, on détermine un signal corrigé (Sicorr) du capteur et on utilise ce signal corrigé (Sicorr) pour déterminer la grandeur de comparaison (Sref).

3. Dispositif selon la revendication 1,
**caractérisé en ce que**
les moyens de surveillance d'au moins l'un des capteurs (301, 302, ..., 30n) contiennent les moyens (309) à l'aide desquels, pour ce capteur (301, 302, ..., 30n), au moins en fonction de la grandeur de référence (Sref) et de préférence en utilisant un modèle mathématique inverse, on détermine une grandeur de référence de capteur (Siref) valable pour le capteur respectif (301, 302, ..., 30n) et on applique cette grandeur de préférence aux moyens de correction.

4. Dispositif selon les revendications 2 et 3,
**caractérisé en ce que**
les moyens de surveillance d'au moins l'un des capteurs (301, 302, ..., 30n) contiennent en outre au moins :
des premiers moyens d'exploitation d'erreur (305) à l'aide desquels, pour ce capteur (301, 302, ..., 30n), au moins en fonction du signal qui représente le décalage (Sioff) du signal généré, on détermine une première erreur de capteur (Sicorr), et/ou
des seconds moyens d'exploitation d'erreur (310) à l'aide desquels, pour ce capteur (301, 302, ..., 30n), au moins en fonction du signal qu'il génère, de la grandeur de référence de capteur (Sref) et d'au moins un signal qui représente une déviation autorisée spécifique au capteur, on détermine une seconde erreur de capteur (Fi).

5. Dispositif selon la revendication 1,
**caractérisé en ce qu'**
on détermine les grandeurs de comparaison (Simod) définies de la même manière pour les capteurs (301, 302, ..., 30n) en utilisant des modèles mathématiques,
et de préférence on vérifie la validité des modèles mathématiques à l'aide de moyens de contrôle (203).

6. Dispositif selon la revendication 1,
**caractérisé en ce qu'**
il comporte un premier capteur (104) qui génère un signal (oméga mess) représentant la vitesse de lacet du véhicule,
un second capteur (105) qui détermine un signal (aymess) représentant l'accélération transversale du véhicule,
un troisième capteur (106) qui détermine un signal (delta mess) représentant l'angle de braquage et
on associe les quatrièmes capteurs (103vr, 103vl, 103hr, 103hl) aux roues du véhicule qui génèrent des signaux représentant les vitesses des roues respectives (nvrmess, nvlmess, nhrmess, nhlmess).

7. Dispositif selon la revendication 1,
**caractérisé en ce que**
les grandeurs de comparaison (Simod) définies de la même manière, obtenues, représentant une grandeur physique, qui est de préférence une grandeur détectée par l'un des capteurs (301, 302, ..., 30n) du véhicule, notamment une vitesse de lacet (oméga mess), et/ou
la grandeur de référence déterminée (Sref) représente une grandeur physique qui correspond de préférence à une grandeur fournie par l'un des capteurs (301, 302, ..., 30n) du véhicule, notamment une vitesse de lacet (oméga mess).

8. Procédé de surveillance de capteur (301, 302, ..., 30n) dans un véhicule et/ou pour corriger leurs signaux, les capteurs générant des signaux représentant chaque fois des grandeurs physiques différentes,
et pour au moins deux capteurs (301, 302, ..., 30n), partant d'au moins ceux des signaux générés pour les capteurs, on détermine des grandeurs de comparaison définies de la même manière,
et selon lequel, partant des grandeurs de comparaison déterminées pour les capteurs (301, 302, ..., 30n), on détermine une grandeur de référence (Sref),
pour au moins un capteur (301, 302, ..., 30n), partant des grandeurs de référence (Sref), on effectue une surveillance du signal de capteur, et/ou pour au moins un capteur (301, 302, ..., 30n), on effectue une correction du signal qu'il génère, au moins en fonction de la grandeur de référence (Sref),
**caractérisé en ce que**
on détermine la grandeur de référence (Sref) par une comparaison des grandeurs de comparaison (Simod) pour déterminer la grandeur de référence (Sref),
et pour cela, on détermine de préférence au moins la grandeur de comparaison (Simod) qui présente la plus grande distance par rapport à la grandeur de référence (Sref) déterminée en dernier lieu, et
on détermine les distances existant entre les grandeurs de comparaison (Simod), ces grandeurs de comparaison n'étant pas prises en compte et partant des grandeurs de comparaison (Simod) et des distances déterminées, en formant une valeur moyenne pondérée on forme la grandeur de référence (Sref), cette grandeur de référence n'étant pas prise en compte ici.
